# EUROPEAN PATENT APPLICATION

(11) **EP 4 651 654 A1**
(43) Date of publication of application: **19.11.2025**
(21) Application number: 24207571.1
(22) Date of filing: 18.10.2024
(51) Int. Cl.: H05K 7/20

(54) **LIQUID COOLING MODULE AND HEAT DISSIPATION ASSEMBLY USING SAME**

(30) Priority: 15.05.2024 US 202463647661 P; 13.09.2024 CN 202411286439
(71) Applicant: Delta Electronics, Inc., Taoyuan City 333 (TW)
(72) Inventor: Ou Yang, Jhen, 333 Taoyuan City (TW); Chiang, Chun-Liang, 333 Taoyuan City (TW); Pan, Wen-Yang, 333 Taoyuan City (TW); Chiu, Hung-Nien, 333 Taoyuan City (TW); Wu, Chun-Han, 333 Taoyuan City (TW)
(74) Representative: Uexküll & Stolberg

(57) **Abstract**

A liquid cooling module (3, 3, 3b, 3c, 3d) and a heat dissipation assembly (1, 1a, 1b, 1c, 1d) using the same are disclosed. The liquid cooling module (3, 3, 3b, 3c, 3d) includes a housing base (2, 2a, 2b, 2c, 2d, 2e, 2f, 2g) with an inflow chamber (21), an outflow chamber (22), manifold chambers (41, 41b, 41c), a partition wall (20, 20a), first through holes (23a, 23b, 23c), second through holes (24a, 24b, 24c) and a diversion structure (25, 25a, 25b, 25c, 25d, 25c, 25f, 25g, 25h, 33a, 33b). The inflow chamber (21) and the outflow chamber (22) are disposed on a first surface (101), and divided by the partition wall (20, 20a). The manifold chambers (41, 41b, 41c) are disposed on a second surface (102). The first through holes (23a, 23b, 23c) and the second through holes (24a, 24b, 24c) are disposed adjacent to two opposite elongated sides, and arranged along a first direction. The manifold chambers (41, 41b, 41c) are in communication with the inflow chamber (21) through the first through holes (23a, 23b, 23c), and in communication with the outflow chamber (22) through to the second through holes (24a, 24b, 24c). The diversion structure (25, 25a, 25b, 25c, 25d, 25c, 25f, 25g, 25h, 33a, 33b) protruding toward the inflow chamber (21) or the outflow chamber (22) provides a diversion function to achieve a uniform flow rate of the parallel flow channels (F 1, F2, F3).

## Description

### FIELD OF THE INVENTION

The present disclosure relates to a heat dissipation assembly, and more particularly to a liquid cooling module with a diversion structure and a heat dissipation assembly using the same, capable of providing uniform flow channels for plural heat-generating electronic devices arranged in an elongated manner, so as to improve the heat dissipation efficiency effectively.

### BACKGROUND OF THE INVENTION

Generally, an electronic device is often combined with a heat dissipation assembly to dissipate the internal heat. For example, a high-efficiency power module used in the inverter is often accompanied with a lot of heat generated therefrom, and must be combined with a water-cooled heat dissipation assembly to achieve an effective effect of heat dissipation.

A traction inverter for the vehicle motor usually includes three high-power modules arranged in a line to form an elongated structure, and the water-cooled heat dissipation assembly combined therewith is mainly designed as a series-connected cooling channel. After the cooling fluid enters the heat exchange chamber from the inlet flow channel, the cooling fluid continuously flows through a plurality of fins for heat dissipation, and finally leaves through the outlet flow channel. Although this architecture is easy to design, it will cause the temperature of the fins near the downstream to be higher, and further makes the power module near the downstream less reliable. In addition, the continuous fin design will further cause the system working fluid impedance to greatly increase, so that the flow rate is decreased. How to design the flow channel of the liquid cooling module and construct a heat dissipation assembly suitable for plural electronic devices arranged in an elongated manner has always been a major subject in the art.

Therefore, there is a need of providing a liquid cooling module and a heat dissipation assembly using the same, wherein a diversion structure is introduced into plural parallel flow channels to effectively reduce the temperature difference of the plural electronic devices and the flow impedance of the cooling fluid in the heat dissipation assembly, and obviate the drawbacks encountered by the prior arts.

### SUMMARY OF THE INVENTION

An object of the present disclosure is to provide a liquid cooling module and a heat dissipation assembly using the same. By introducing a diversion structure into plural parallel flow channels, the temperature difference of the plural electronic devices and the flow impedance of the cooling fluid in the heat dissipation assembly are reduced effectively.

Another object of the present disclosure is to provide a liquid cooling module and a heat dissipation assembly using the same. In order to meet the heat dissipation requirements of plural electronic devices arranged in a single direction, the liquid cooling module provides a parallel flow channel design in an elongated housing base. The top side of the housing base is divided into a plurality of diversion chambers, which is connected to heat dissipation fins thermally coupled with a plurality of electronic devices. The bottom side of the housing base is divided into an inflow chamber and an outflow chamber through a partition wall. Furthermore, by disposing at least one diversion structure, the cooling fluid entering the inflow chamber is evenly divided into equal portions and then enters a plurality of diversion chambers through a plurality of through holes disposed adjacent to the elongated lateral side. Then, the cooling fluid is converged into the outflow chamber through a plurality of through holes disposed on the opposite elongated lateral side, so as to discharge the cooling fluid out of the heat dissipation assembly. The plurality of manifold chambers correspond to the plurality of through holes on both elongated lateral sides to form a plurality of transverse flow channels. The plurality of transverse flow channels are connected between the inflow chamber and the outflow chamber in parallel, and has the cooling fluid flowing through with an equal flowrate, so as to dissipate the heat from the plurality of electronic devices, respectively. Since the flow direction of the plurality of transverse flow channels is perpendicular to the extension direction of the elongated lateral sides rather than along the extension direction of the elongated lateral side, a short path design is adopted, so that the transverse flow channels of the plurality of manifold chambers are located between two opposite elongated lateral sides of the elongated housing base. It helps to reduce the length of the flow channels and improve the uniform heat dissipation performance. Thereby, the cooling-flow-channel inlet and the cooling-flow-channel outlet can be disposed at different ends of the elongated lateral side, respectively. Furthermore, the through holes extended along the two opposite elongated lateral sides and the manifold chambers connected therebetween have the same width, and the cooling fluid flowing through the plurality of flow channels formed can be uniformly divided by at least one diversion structure, so that the plurality of electronic devices corresponding to the plurality of manifold chambers in the heat dissipation assembly have similar heat dissipation conditions, which can quickly and evenly take away the heat generated by the plurality of electronic devices. Thus, the overall heat dissipation efficiency is improved effectively.

In accordance with an aspect of the present disclosure, a liquid cooling module is provided and includes a housing base and a bottom cover. The housing base has a first lateral side, a second lateral side, a third lateral side, a fourth lateral side, a first surface and a second surface. The first lateral side and the second lateral side are opposite to each other and extended along a first direction. The bottom cover is spatially corresponding to the first surface and connected to the first lateral side, the second lateral side, the third lateral side and the fourth lateral side. The housing base includes an inflow chamber, an outflow chamber, a plurality of manifold chambers, a partition wall, a plurality of first through holes, a plurality of second through holes and at least one diversion structure. The inflow chamber is disposed between the first surface and the bottom cover. The outflow chamber is disposed between the first surface and the bottom cover. The plurality of manifold chambers are disposed on the second surface and configured to be thermally coupled with a plurality of fins. The partition wall is disposed between the inflow chamber and the outflow chamber and connected between the first surface and the bottom cover. The plurality of first through holes are disposed adjacent to the first lateral side, arranged along the first direction, and in fluid communication between the inflow chamber and the plurality of manifold chambers, respectively. The plurality of second through holes are disposed adjacent to the second lateral side, arranged along the first direction, and in fluid communication between the outflow chamber and the plurality of manifold chambers, wherein the plurality of manifold chambers correspond to the plurality of first through holes adjacent to the first lateral side, and correspond to the plurality of second through holes adjacent to the second lateral side. The at least one diversion structure is disposed on the bottom cover, protrudes toward the inflow chamber or the outflow chamber, to perform a diversion function, wherein a cooling fluid enters the plurality of manifold chambers from the inflow chamber through the plurality of first through holes, respectively, to exchange heat with the plurality of fins, and then the cooling fluid flows into the outflow chamber from the plurality of manifold chambers through the plurality of second through holes, respectively, to discharge.

In an embodiment, the liquid cooling module further includes a cooling-flow-channel inlet and a cooling-flow-channel outlet. The cooling-flow-channel inlet passes through the bottom cover, and is disposed on the bottom cover and in fluid communication with the inflow chamber. The cooling-flow-channel outlet passes through the bottom cover, and is disposed on the bottom cover and in fluid communication with the outflow chamber.

In an embodiment, the at least one diversion structure is circular in shape and located on a midline between each adjacent two of the plurality of first through holes or on a midline between each adjacent two of the plurality of second through holes to provide a diversion function.

In an embodiment, the at least one diversion structure is in an elongated strip shape, spaced apart from the partition wall, and extended along a second direction, and the second direction is perpendicular to the first direction.

In an embodiment, the at least one diversion structure is formed by irregular bending of the partition wall.

In an embodiment, the plurality of first through holes and the plurality of second through holes are slotted holes extended along the first direction.

In an embodiment, the liquid cooling module further includes a top cover, wherein the top cover has a top side and a bottom side opposite to each other, the bottom side is assembled with the first lateral side, the second lateral side, the third lateral side, the fourth lateral side and the second surface of the housing base to form the plurality of manifold chambers, the plurality of fins are accommodated in the plurality of manifold chambers and extended from the bottom side toward the second surface, and a heat dissipation surface is disposed on the top side and thermally coupled with the plurality of fins.

In an embodiment, the plurality of manifold chambers, the plurality of first through holes and the plurality of second through holes are equal in number of M, M is an integer, and M ≧ 2.

In an embodiment, the plurality of manifold chambers, the plurality of first through holes and the plurality of second through holes are correspondingly cooperated to form M flow channels, and the M flow channels have a flow direction perpendicular to the first direction.

In accordance with another aspect of the present disclosure, a liquid cooling module is provided and includes a housing base having a first lateral side, a second lateral side, a third lateral side, a fourth lateral side, a first surface and a second surface, wherein the first lateral side and the second lateral side are opposite to each other and extended along a first direction; and the housing base includes an inflow chamber, an outflow chamber, a plurality of manifold chambers, a partition wall, a plurality of first through holes, a plurality of second through holes and at least one diversion structure. The inflow chamber is disposed on the first surface. The outflow chamber is disposed on the first surface. The plurality of manifold chambers are disposed on the second surface and configured to be thermally coupled with a plurality of fins. The partition wall is disposed between the inflow chamber and the outflow chamber. The plurality of first through holes are disposed adjacent to the first lateral side, arranged along the first direction, and in fluid communication between the inflow chamber and the plurality of manifold chambers, respectively. The plurality of second through holes are disposed adjacent to the second lateral side, arranged along the first direction, and in fluid communication between the outflow chamber and the plurality of manifold chambers. The plurality of manifold chambers correspond to the plurality of first through holes adjacent to the first lateral side, and correspond to the plurality of second through holes adjacent to the second lateral side. The at least one diversion structure is disposed on the first surface, located in the inflow chamber or the outflow chamber, or connected to the partition wall, to perform a diversion function, wherein a cooling fluid enters the plurality of manifold chambers from the inflow chamber through the plurality of first through holes, respectively, to exchange heat with the plurality of fins, and then the cooling fluid flows into the outflow chamber from the plurality of manifold chambers through the plurality of second through holes, respectively, to discharge.

In an embodiment, the liquid cooling module further includes a cooling-flow-channel inlet and a cooling-flow-channel outlet. The cooling-flow-channel inlet is disposed adjacent to the third lateral side and in fluid communication with the inflow chamber. The cooling-flow-channel outlet is disposed adjacent to the fourth lateral side and in fluid communication with the outflow chamber.

In an embodiment, the liquid cooling module further includes a bottom cover, wherein the bottom cover is assembled with the first lateral side, the second lateral side, the third lateral side, the fourth lateral side and the first surface, and connected to the partition wall to form the inflow chamber and the outflow chamber, wherein the cooling-flow-channel inlet and the cooling-flow-channel outlet pass through the bottom cover and are disposed on the bottom cover.

In an embodiment, the at least one diversion structure has a first end connected to the partition wall and a second end extended along a second direction, and the second direction is perpendicular to the first direction.

In an embodiment, the at least one diversion structure is circular in shape and located on a midline between each adjacent two of the plurality of first through holes or on a midline between each adjacent two of the plurality of second through holes to provide the diversion function.

In an embodiment, the at least one diversion structure is in an elongated strip shape, spaced apart from the partition wall, and extended along a second direction, and the second direction is perpendicular to the first direction.

In an embodiment, the at least one diversion structure is formed by irregular bending of the partition wall.

In an embodiment, the plurality of first through holes and the plurality of second through holes are slotted holes extended along the first direction.

In an embodiment, the liquid cooling module further includes a top cover, wherein the top cover has a top side and a bottom side opposite to each other, the bottom side is assembled with the first lateral side, the second lateral side, the third lateral side, the fourth lateral side and the second surface of the housing base to form the plurality of manifold chambers, the plurality of fins are accommodated in the plurality of manifold chambers and extended from the bottom side toward the second surface, and a heat dissipation surface is disposed on the top side and thermally coupled with the plurality of fins.

In an embodiment, the plurality of manifold chambers, the plurality of first through holes and the plurality of second through holes are equal in number of M, M is an integer, and M ≧ 2.

In accordance with a further aspect of the present disclosure, a heat dissipation assembly is provided and includes a liquid cooling module. The liquid cooling module includes a housing base and a bottom cover. The housing base has a first lateral side, a second lateral side, a third lateral side, a fourth lateral side, a first surface and a second surface, the first lateral side and the second lateral side are opposite to each other and extended along a first direction The bottom cover is spatially corresponding to the first surface and connected to the first lateral side, the second lateral side, the third lateral side and the fourth lateral side. The housing base includes an inflow chamber, an outflow chamber, a partition wall, a plurality of first through holes, a plurality of second through holes and at least one diversion structure. The inflow chamber is disposed between the first surface and the bottom cover. The outflow chamber is disposed between the first surface and the bottom cover. The plurality of manifold chambers are disposed on the second surface and configured to be thermally coupled with a plurality of fins. The partition wall is disposed between the inflow chamber and the outflow chamber and connected between the first surface and the bottom cover. The plurality of first through holes are disposed adjacent to the first lateral side, arranged along the first direction, and in fluid communication between the inflow chamber and the plurality of manifold chambers, respectively. The plurality of second through holes are disposed adjacent to the second lateral side, arranged along the first direction, and in fluid communication between the outflow chamber and the plurality of manifold chambers. The plurality of manifold chambers correspond to the plurality of first through holes adjacent to the first lateral side, and correspond to the plurality of second through holes adjacent to the second lateral side. The at least one diversion structure is disposed on the bottom cover or the first surface, and protrudes toward the inflow chamber or the outflow chamber, to perform a diversion function, wherein a cooling fluid enters the plurality of manifold chambers from the inflow chamber through the plurality of first through holes, respectively, to exchange heat with the plurality of fins, and then the cooling fluid flows into the outflow chamber from the plurality of manifold chambers through the plurality of second through holes, respectively, to discharge.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 and FIG. 2 are perspective structural views illustrating a heat dissipation assembly according to a first embodiment of the present disclosure;
FIG. 3 and FIG. 4 are exploded views illustrating the heat dissipation assembly according to the first embodiment of the present disclosure;
FIG. 5 is a schematic diagram showing the flow direction of the cooling fluid on the first surface of the liquid cooling module according to the first embodiment of the present disclosure;
FIG. 6 is a schematic diagram showing the flow direction of the cooling fluid on the second surface of the liquid cooling module according to the first embodiment of the present disclosure;
FIG. 7 and FIG. 8 are exploded views illustrating a heat dissipation assembly according to a second embodiment of the present disclosure;
FIG. 9 is a schematic diagram showing the flow direction of the cooling fluid on the first surface of the liquid cooling module according to the second embodiment of the present disclosure;
FIG. 10 is an exploded views illustrating a heat dissipation assembly according to a third embodiment of the present disclosure;
FIG. 11 is a schematic diagram showing the flow direction of the cooling fluid on the first surface of the liquid cooling module according to the third embodiment of the present disclosure;
FIG. 12 is an exploded views illustrating a heat dissipation assembly according to a fourth embodiment of the present disclosure;
FIG. 13 is a schematic diagram showing the flow direction of the cooling fluid on the first surface of the liquid cooling module according to the fourth embodiment of the present disclosure;
FIG. 14 to FIG. 16 illustrate other examples of different diversion structures for the liquid cooling module of the present disclosure;
FIG. 17 and FIG. 18 are perspective structural views illustrating a heat dissipation assembly according to a fifth embodiment of the present disclosure;
FIG. 19 and FIG. 20 are exploded views illustrating the heat dissipation assembly according to the fifth embodiment of the present disclosure;
FIG. 21 is a schematic diagram showing the flow direction of the cooling fluid on the first surface of the liquid cooling module according to the fifth embodiment of the present disclosure; and
FIG. 22 is a schematic diagram showing the flow direction of the cooling fluid on the second surface of the liquid cooling module according to the fifth embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed. For example, the formation of a first feature over or on a second feature in the description that follows may include embodiments in which the first and second features are formed in direct contact, and may also include embodiments in which additional features may be formed between the first and second features, such that the first and second features may not be in direct contact. In addition, the present disclosure may repeat reference numerals and/or letters in the various examples. This repetition is for the purpose of simplicity and clarity and does not in itself dictate a relationship between the various embodiments and/or configurations discussed. Further, spatially relative terms, such as "upper," "lower," "top," "bottom" and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly. When an element is referred to as being "connected," or "coupled," to another element, it can be directly connected or coupled to the other element or intervening elements may be present. Although the wide numerical ranges and parameters of the present disclosure are approximations, numerical values are set forth in the specific examples as precisely as possible. In addition, although the "first," "second," "third," and the like terms in the claims be used to describe the various elements can be appreciated, these elements should not be limited by these terms, and these elements are described in the respective embodiments are used to express the different reference numerals, these terms are only used to distinguish one element from another element. For example, a first element could be termed a second element, and, similarly, a second element could be termed a first element, without departing from the scope of example embodiments.

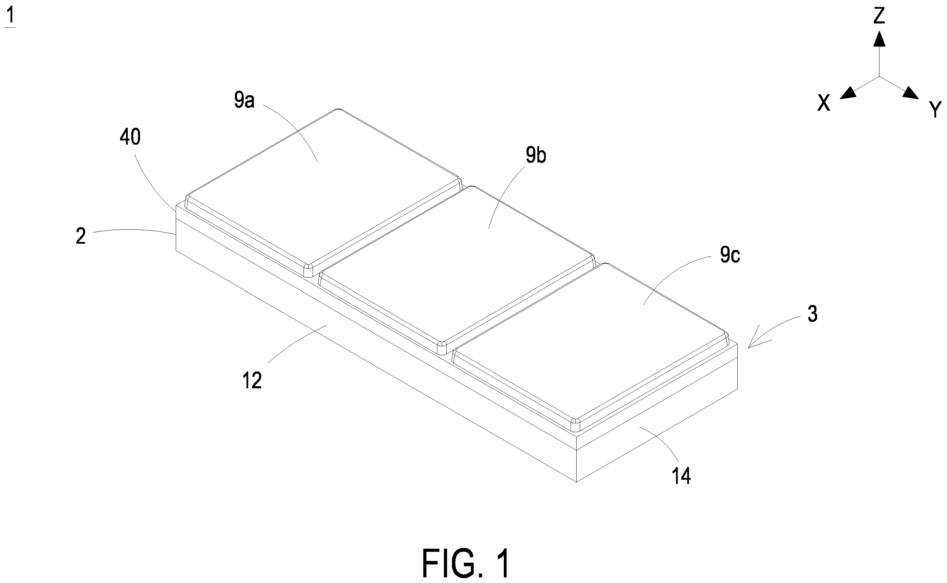

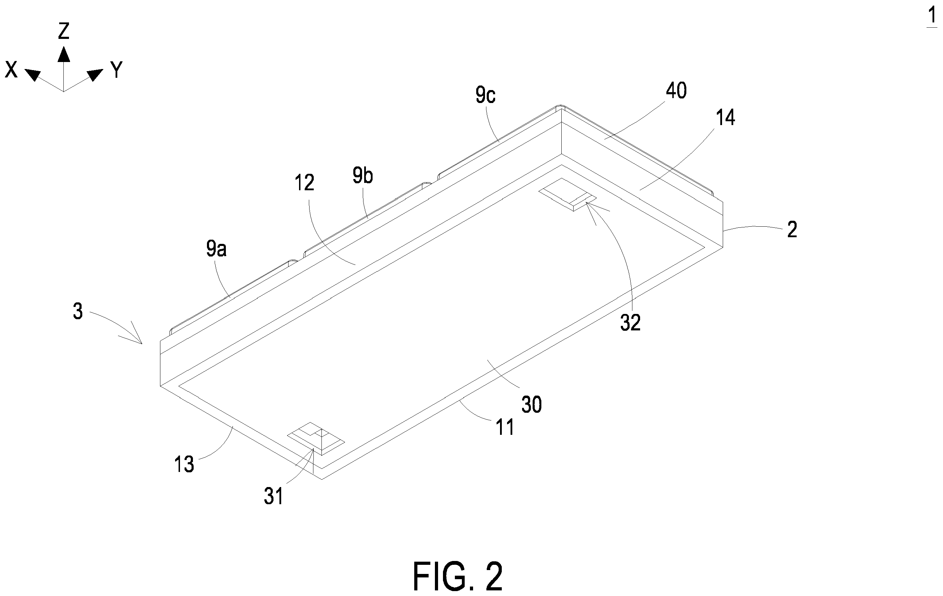

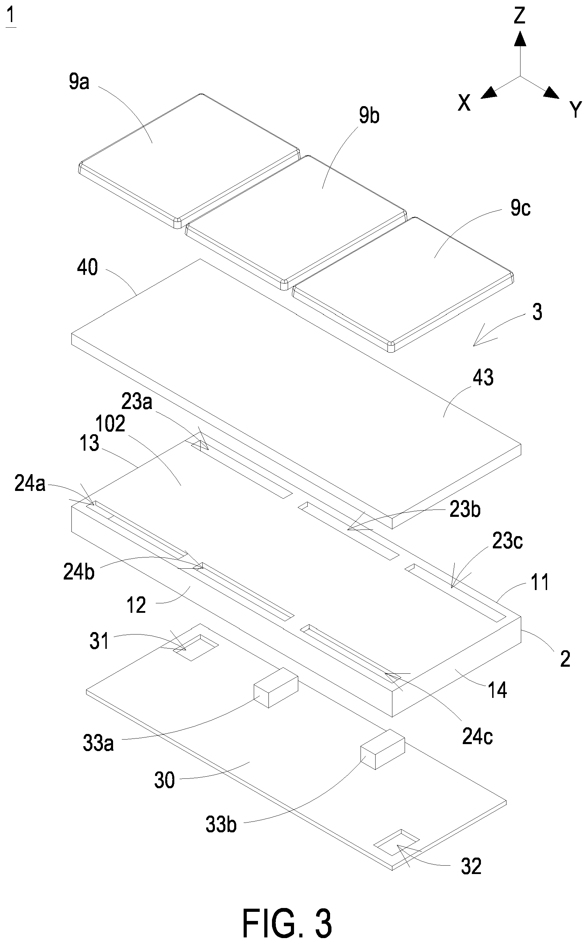

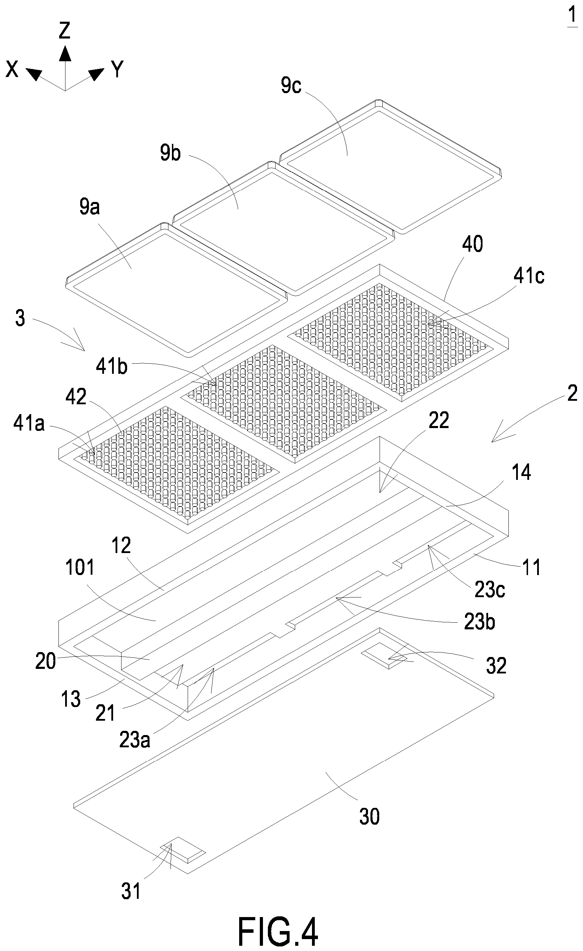

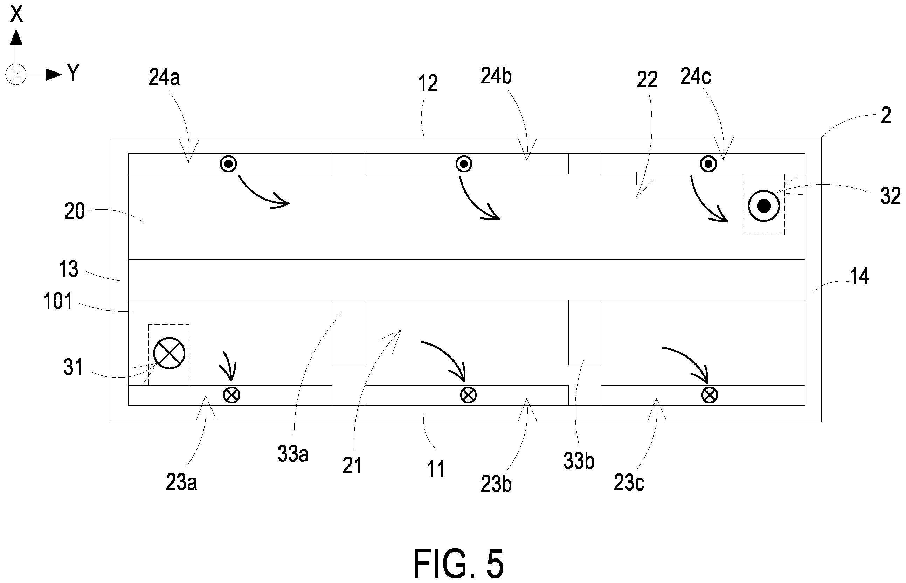

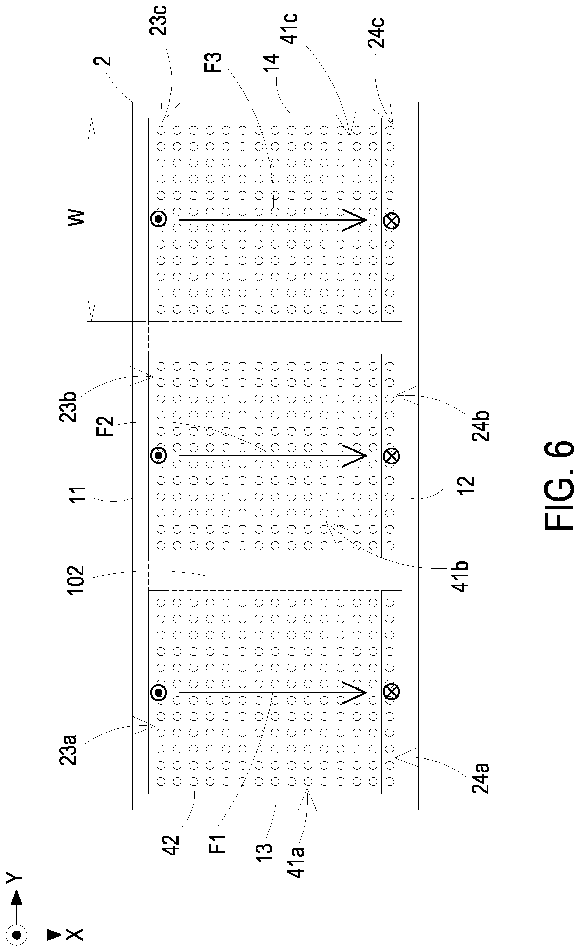

FIG. 1 and FIG. 2 are perspective structural views illustrating a heat dissipation assembly according to a first embodiment of the present disclosure. FIG. 3 and FIG. 4 are exploded views illustrating the heat dissipation assembly according to the first embodiment of the present disclosure. FIG. 5 is a schematic diagram showing the flow direction of the cooling fluid on the first surface of the liquid cooling module according to the first embodiment of the present disclosure. FIG. 6 is a schematic diagram showing the flow direction of the cooling fluid on the second surface of the liquid cooling module according to the first embodiment of the present disclosure. Please refer to FIGS. 1 to 6. In the embodiment, the present disclosure provides a heat dissipation assembly 1 includes an elongated liquid cooling module 3 and a plurality of electronic devices 9a, 9b, 9c. The liquid cooling module 3 includes an elongated housing base 2, a top cover 40 and a bottom cover 30. In the embodiment, the housing base 2 has a first lateral side 11, a second lateral side 12, a third lateral side 13, a fourth lateral side 14, a first surface 101 and a second surface 102. The first lateral side 11 and the second lateral side 12 are elongated lateral sides and opposite to each other. Preferably but not exclusively, the first lateral side 11 and the second lateral side 12 are extended along a first direction, such as the Y axial direction. The third lateral side 13 and the fourth lateral side 14 are short lateral sides opposite to each other, and connected between the first lateral side 11 and the second lateral side 12, respectively. In addition, the first surface 101 and the second surface 102 are the bottom side and the top side of the housing base 2, respectively, which are two sides opposite to each other. In the embodiment, the distance between the first lateral side 11 and the second lateral side 12 is smaller than the distance between the third lateral side 13 and the fourth lateral side 14. That is, the length of the elongated lateral sides of the first lateral side 11 and the second lateral side 12 is greater than the length of the short lateral sides of the third lateral side 13 and the fourth lateral side 14, so as to form a long and narrow rectangular housing base 2. In the embodiment, the housing base 2 includes an inflow chamber 21, an outflow chamber 22, a plurality of manifold chambers 41a, 41b, 41c, a partition wall 20, a plurality of first through holes 23a, 23b, 23c, a plurality of second through holes 24a, 24b, 24c, at least one diversion structure 33a, 33b, a cooling-flow-channel inlet 31 and a cooling-flow-channel outlet 32. In the embodiment, the bottom cover 30 is spatially corresponding to the first surface 101 and connected to the first lateral side 11, the second lateral side 12, the third lateral side 13 and the fourth lateral side 14. The inflow chamber 21 is disposed between the first surface 101 and the bottom cover 30. The outflow chamber 22 is disposed between the first surface 101 and the bottom cover 30. The partition wall 20 is disposed between the inflow chamber 21 and the outflow chamber 22, and connected between the first surface 101 and the bottom cover 30. Notably, in the embodiment, one side of the bottom cover 30 is assembled with the first lateral side 11, the second lateral side 12, the third lateral side 13 and the fourth lateral side 14 of the housing base 2, and connected to the partition wall 20, so as to form the inflow chamber 21 and the outflow channel 22. The cooling-flow-channel inlet 31 and the cooling-flow-channel outlet 32 pass through the bottom cover 30 and are disposed on the bottom cover 30. Moreover, in the embodiment, the cooling-flow-channel inlet 31 is disposed adjacent to the third lateral side 13 and in fluid communication with the inflow chamber 21. The cooling-flow-channel outlet 32 is disposed adjacent to the fourth lateral side 14 and in fluid communication with the outflow chamber 22. Certainly, in the present disclosure, the assembling method of the bottom cover 30 and the housing base 2 is not limited thereto. Notably, after the bottom cover 30 is assembled with the elongated housing base 2, the space on the first surface 101 is divided into the inflow chamber 21 and the outflow chamber 22 by the partition wall 20. Preferably but not exclusively, the inflow chamber 21 and the outflow chamber 22 are symmetrical to each other. Certainly, the present disclosure is not limited thereto. Preferably but not exclusively, in the embodiment, the top cover 40 and the housing base 2 of the liquid cooling module 3 are assembled with each other to form the plurality of manifold chamber 41a, 41b, 41c. The top cover 40 includes a top side and a bottom side opposite to each other. In the embodiment, the heat dissipation surface 43 corresponding to the electronic devices 9a, 9b, 9c is disposed on the top side of the top cover 40, and the bottom side of the top cover 40 is assembled with the first lateral side 11, the second lateral side 12, the third lateral side 13, the fourth lateral side 14 and the second surface 102 of the housing base 2, so as to form the plurality of manifold chambers 41a, 41b, 41c. Certainly, in the present disclosure, the assembling method of the top cover 40 and the housing base 2 is not limited thereto, and not redundantly described herein.

Preferably but not exclusively, the plurality of fins 42 are disposed on the bottom side of the top cover 40, accommodated in the plurality of manifold chambers 41a, 41b, 41c, and extended from the bottom side of the top cover 40 toward the second surface 102. Preferably but not exclusively, in other embodiments, the plurality of fins 42 are disposed on the second surface 102, connected to the top cover 40, and thermally coupled to the heat dissipation surface 40 on the top side. Certainly, the present disclosure is not limited thereto. By assembling the top cover 40 and the housing base 2, the plurality of manifold chambers 41a, 41b, 41c are disposed on the second surface 102 , and thermally coupled to the plurality of fins 42. Furthermore, the plurality of fins 42 are connected to the heat dissipation surface 43 to dissipate heat from the plurality of electronic devices 9a, 9b, 9c thereon.

In the embodiment, the plurality of first through holes 23a, 23b, 23c are disposed adjacent to the first lateral side 11, arranged along the first direction (i.e., the Y axial direction), and in fluid communication between the inflow chamber 21 and the plurality of manifold chambers 41a, 41b, 41c, respectively. The plurality of second through holes 24a, 24b, 24c are disposed adjacent to the second lateral side 12, arranged along the first direction (i.e., the Y axial direction), and in fluid communication between the outflow chamber 22 and the plurality of manifold chambers 41a, 41b, 41c. In the embodiment, the plurality of manifold chambers 41a, 41b, 41c correspond to the plurality of first through holes 23a, 23b, 23c adjacent to the first lateral side 11, and correspond to the plurality of second through holes 24a, 24b, 24c adjacent to the second lateral side 12. The respective numbers of the plurality of manifold chambers 41a, 41b, 41c, the plurality of first through holes 23a, 23b, 23c and the plurality of second through holes 24a, 24b, 24c are equal to three. The manifold chamber 41a, the first thorough hole 23a and the second through hole 24a are cooperated to form a flow channel F1 correspondingly. The manifold chamber 41b, the first through hole 23b and the second through hole 24b are cooperated to form a flow channel F2 correspondingly. The manifold chamber 41c, the first through hole 23c and the second through hole 24c are cooperated to formed a flow channel F3 correspondingly. The three flow channels F1, F2, F3 are connected in parallel between the inflow chamber 21 and the outflow chamber 22, and the flow direction of the three flow channels F1, F2, F3 is perpendicular to the first direction (i.e., the Y axial direction) and parallel to X axial direction.

In the embodiment, the diversion structures 33a, 33b are disposed on one side of the bottom cover 30, protrudes toward the inflow chamber 21. Preferably but not exclusively, the diversion structure 33a, 33b are close to the first surface 101 but not in contact with the first surface 101. The diversion structures 33a, 33b are, for example, in the shape of a long rectangle. The extension length of the diversion structures 33a, 33b along the second direction (i.e., the X axials direction) is adjustable according to the practical requirements. The diversion structures 33a, 33b have first ends in contact with the partition wall 20, and second ends extended along the second direction parallel to the X axial direction. The second direction is perpendicular to the first direction. Thereby, the diversion structure 33a provides the diversion function for the adjacent two first through holes 23a, 23b. The diversion structure 33b provides the diversion function for the adjacent two first through holes 23b, 23c. In the present disclosure, with the arrangement of the diversion structures 33a, 33b, it allows the parallel flow channels F1, F2, F3 to achieve a uniform flow rate and meet the heat dissipation requirements of the plurality of electronic devices 9a, 9b, 9c arranged in one single direction. In other embodiments, although any one of the diversion structures 33a, 33b is omitted, the cooling fluid flowing can still be uniformly divided, so that the parallel flow channels F1, F2, F3 achieve a uniform flow rate and meet the heat dissipation requirements of the plurality of electronic devices 9a, 9b, 9c arranged in the single direction.

Preferably but not exclusively, in the embodiment, the plurality of electronic devices 9a, 9b, 9c are three power devices used in a multi-phase inverter and configured to output the driving current of the motor. Since each power device needs to have its own input and output electrical connections, it needs to be arranged in a single direction and electrically connected to the outside on both elongated lateral sides of the heat dissipation assembly 1. In order to meet the heat dissipation requirements of the plurality of electronic devices 9a, 9b, 9c arranged in one single direction, the heat dissipation assembly 1 has the plurality of electronic devices 9a, 9b, 9c disposed on the heat dissipation surface 43, arranged along the first direction (i.e., the Y axial direction), and thermally coupled to the plurality of fins 42. In case of that the plurality of electronic devices 9a, 9b, 9c are served as the power devices of the aforementioned multi-phase inverter, the electronic devices 9a, 9b, 9c can be electrically connected to the outside via the first lateral side 11 or the second lateral side 12. Certainly, the present disclosure is not limited thereto. In the embodiment, after a cooling fluid is introduced into the inflow chamber 21 through the cooling-flow-channel inlet 31, the cooling fluid is evenly divided into the plurality of first through holes 23a, 23b, 23c through the diversion function of the diversion structures 33a, 33b in the inflow chamber 21, and enters the plurality of manifold chambers 41a, 41b, 41c, respectively. The cooling fluid in the plurality of manifold chamber 41a, 41b, 41c exchanges heat with the plurality of fins 42 to dissipate heat from the plurality of electronic devices 9a, 9b, 9c. Thereafter, the cooling fluid in the plurality of manifold chambers 41a, 41b, 41c flows to the outflow chamber 22 through the confluence in the plurality of second through holes 24a, 24b, 24c respectively. Finally, the cooling fluid is discharged out of the outflow chamber 22 through the cooling channel outlet 32.

In the embodiment, the plurality of manifold chambers 41a, 41b, 41c correspond to the first through holes 23a, 23b, 23c adjacent to the first lateral side 11, and correspond to the second through holes 24a, 24b, 24c adjacent to the second lateral side 12, so that a plurality of transverse flow channels F1, F2, F3 are formed. Through the diversion function of the diversion structures 33a, 33b, the plurality of transverse flow channels F1, F2, F3 are connected in parallel between the inflow chamber 21 and the outflow chamber 22. In that, the cooling fluid with equal flow rate is evenly divided to dissipate the heat from the plurality of electronic devices 9a, 9b, 9c, respectively. Notably, the flow direction of the plurality of transverse flow channels F1, F2, F3 is perpendicular to the elongated lateral sides, that is, the extended direction of the first lateral side 11 and the second lateral side 12. The flow direction is not designed to extend along the elongated lateral sides, but is designed in a short path, so that the cooling fluid flows through the transverse flow channels F1, F2, F3 of the plurality of manifold chambers 41a, 41b, 41c in the shortest path of the elongated housing base 2. It helps to reduce the length of the flow channels and improve the uniform heat dissipation performance. In this way, the cooling-flow-channel inlet 31 and the cooling- flow-channel outlet 32 can be arranged at different ends of the elongated lateral side. Preferably but not exclusively, the cooling-flow-channel inlet 31 and the cooling- flow-channel outlet 32 are arranged adjacent to the third lateral side 13 and the fourth lateral side 14, respectively . In the embodiment, the plurality of first through holes 23a, 23b, 23c and the plurality of second through holes 24a, 24b, 24c are all slotted holes, which are extended along the first direction (i.e., the Y axial direction). Moreover, the plurality of first through holes 23a, 23b, 23c, the plurality of second through holes 24a, 24b, 24c and the plurality of manifold chambers 41b, 41c have an identical width W in view of the first direction. The plurality of flow channels F1, F2, F3 are formed and cooperated with the diversion structures 33a, 33b to achieve the even diversion, so that the plurality of electronic devices 9a, 9b, 9c corresponding to the plurality of manifold chambers 41a, 41b, 41c in the heat dissipation assembly 1 have similar heat dissipation conditions, which can quickly and evenly take away the heat generated by the plurality of electronic devices 9a, 9b, 9c. Thus, the overall heat dissipation efficiency is improved effectively.

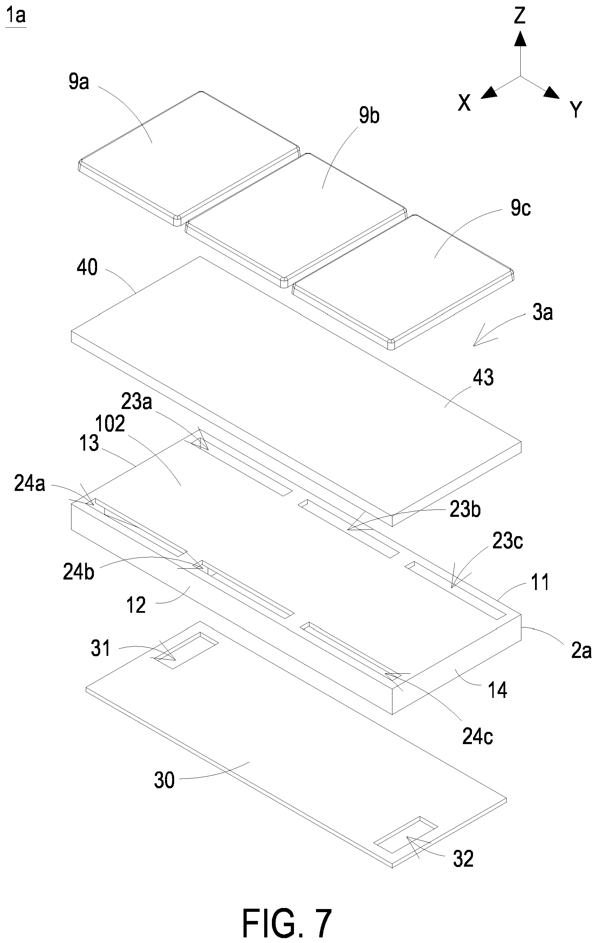

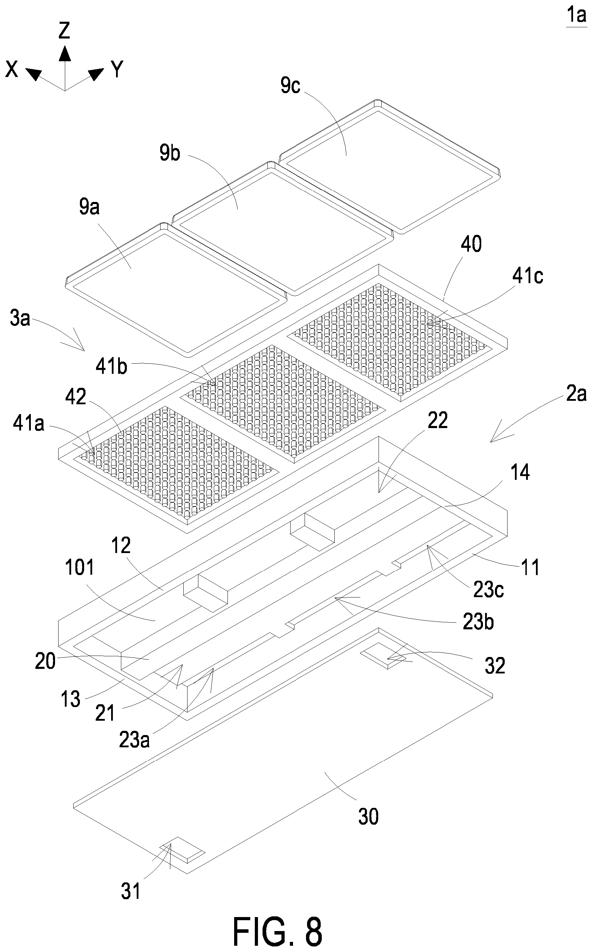

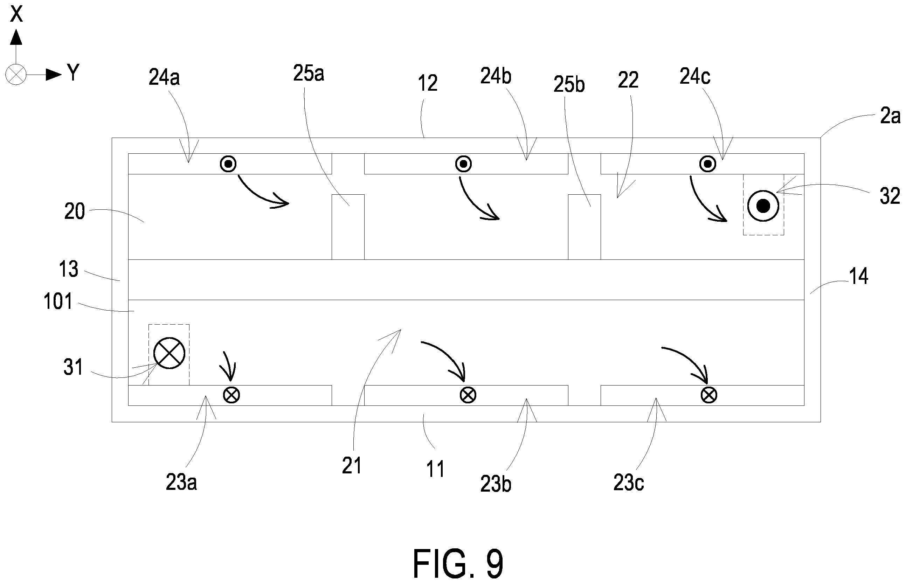

FIG. 7 and FIG. 8 are exploded views illustrating a heat dissipation assembly according to a second embodiment of the present disclosure. FIG. 9 is a schematic diagram showing the flow direction of the cooling fluid on the first surface of the liquid cooling module according to the second embodiment of the present disclosure. In the embodiment, the structures, elements and functions of the heat dissipation assembly 1a and the liquid cooling module 3a are similar to those of the heat dissipation assembly 1 and the fluid cooling module 3 of FIG. 1 to FIG. 6, and are not redundantly described herein. Please refer to FIG. 6 to FIG. 9. In the embodiment, the diversion structures 25a, 25b are disposed on the first surface 101 of the housing base 2a and located in the outflow chamber 22. Preferably but not exclusively, the diversion structures 25a, 25b are protruded from the first surface 101 toward the bottom cover 30, but not limited to contacting the bottom cover 30. Preferably but not exclusively, the diversion structures 25a, 25b are in the shape of a long rectangle, and the extension length in the second direction (i.e., the X-axis direction) is adjustable according to the practical requirements. First ends of the diversion structures 25a, 25b are connected to the partition wall 20, and second ends of the diversion structures 25a, 25b are extended along the second direction parallel to the X axial direction. The second direction is perpendicular to the first direction. Thereby, the diversion structure 25a provides the diversion function for the adjacent two second through holes 24a, 24b. The diversion structure 25b provides the diversion function for the adjacent two second through holes 24b, 24c. In the present disclosure, with the arrangement of the diversion structures 25a, 25b, it allows the parallel flow channels F1, F2, F3 to achieve a uniform flow rate and meet the heat dissipation requirements of the plurality of electronic devices 9a, 9b, 9c arranged in one single direction. In other embodiments, the diversion structures 25a, 25b are moved to the inflow chamber 21 or one of the diversion structures 25a, 25b is omitted, and the cooling fluid flowing can still be uniformly divided, so that the parallel flow channels F1, F2, F3 achieve a uniform flow rate and meet the heat dissipation requirements of the plurality of electronic devices 9a, 9b, 9c arranged in the single direction.

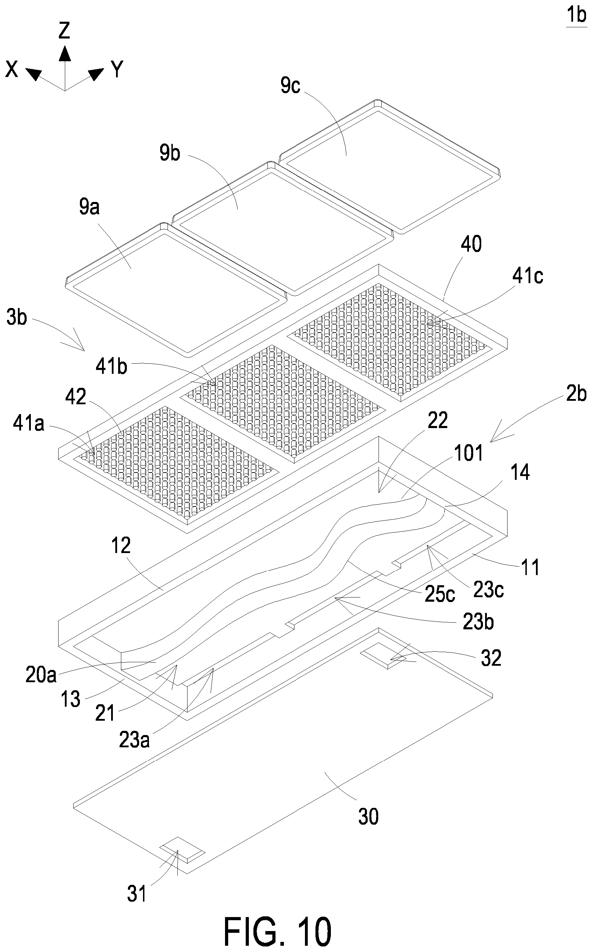

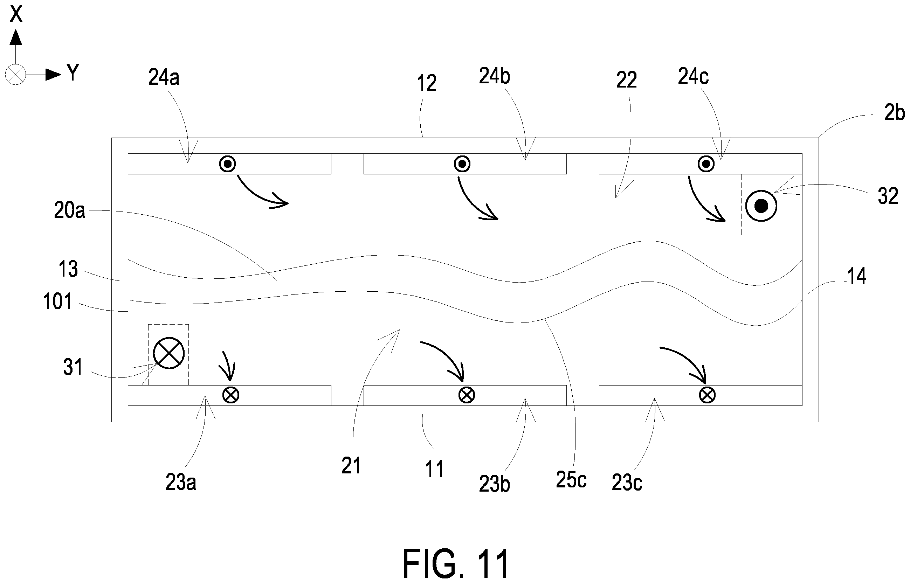

FIG. 10 is an exploded views illustrating a heat dissipation assembly according to a third embodiment of the present disclosure. FIG. 11 is a schematic diagram showing the flow direction of the cooling fluid on the first surface of the liquid cooling module according to the third embodiment of the present disclosure. In the embodiment, the structures, elements and functions of the heat dissipation assembly 1b and the liquid cooling module 3b are similar to those of the heat dissipation assembly 1 and the liquid cooling module 3 of FIG. 1 to FIG. 6, and are not redundantly described herein. Please refer to FIG. 6, FIG. 10 and FIG. 11. In the embodiment, the partition wall 20a of the housing base 2b is irregularly curved to divide the inflow chamber 21 and the outflow chamber 22. Through the irregular bending of the partition wall 20a, it can also provide the diversion function corresponding to the plurality of first through holes 23a, 23b, 23c or the plurality of second through holes 24a, 24b, 24c, so that the parallel flow channels F1, F2, F3 can achieve a uniform flow rate and meet the heat dissipation requirements of the plurality of electronic devices 9a, 9b, 9c arranged in one single direction. In other words, the at least one diversion structure 25c is formed by irregular bending of the partition wall 20a. In the embodiment, after the cooling fluid is introduced into the inflow chamber 21 through the cooling-flow-channel inlet 31, the cooling fluid is evenly divided into the plurality of first through holes 23a, 23b, 23c through the diversion function of the at least one diversion structure 25c in the inflow chamber 21, and enters the plurality of manifold chambers 41a, 41b, 41c, respectively. The cooling fluid in the plurality of manifold chamber 41a, 41b, 41c exchanges heat with the plurality of fins 42 to dissipate heat from the plurality of electronic devices 9a, 9b, 9c. Thereafter, the cooling fluid in the plurality of manifold chambers 41a, 41b, 41c flows to the outflow chamber 22 through the confluence in the plurality of second through holes 24a, 24b, 24c respectively. Finally, the cooling fluid is discharged out of the outflow chamber 22 through the cooling channel outlet 32. Certainly, the present disclosure is not limited thereto.

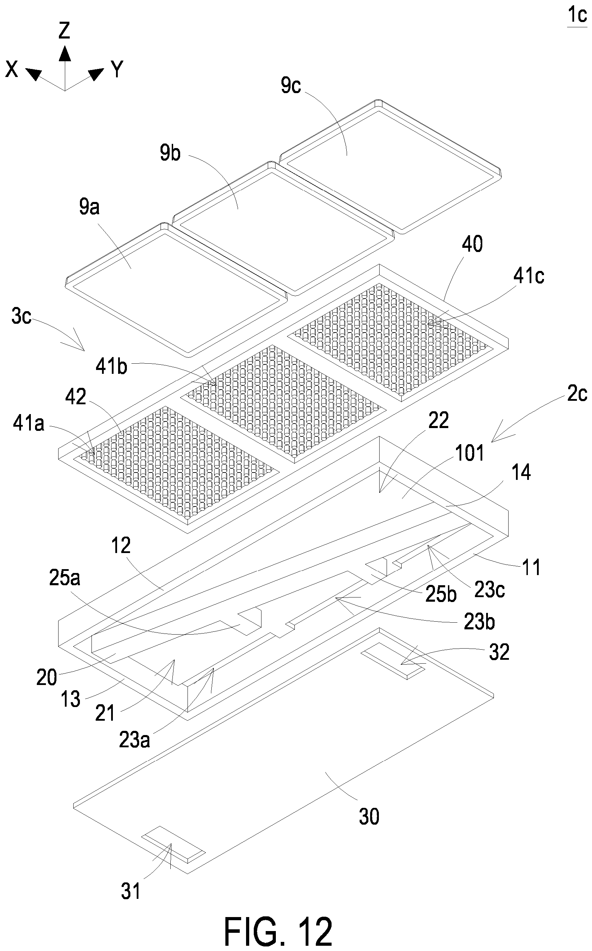

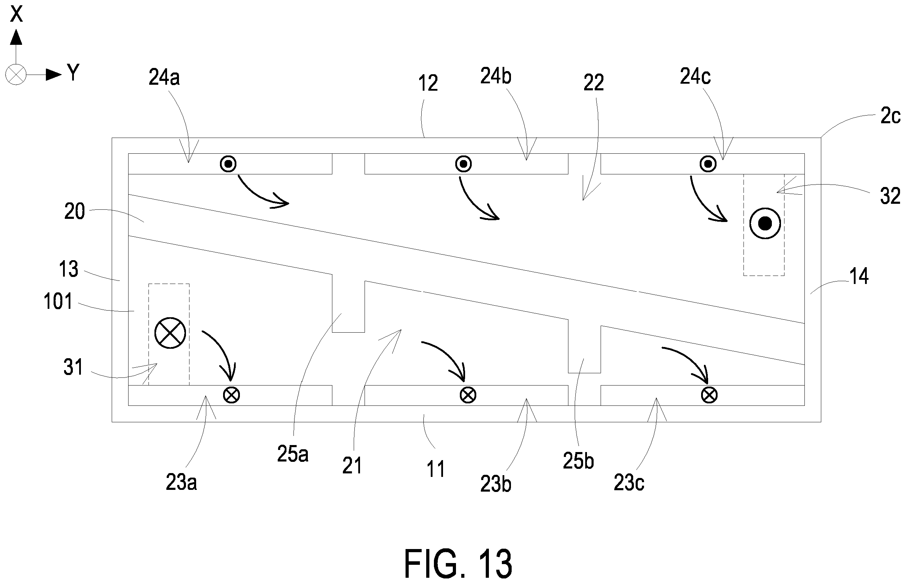

FIG. 12 is an exploded views illustrating a heat dissipation assembly according to a fourth embodiment of the present disclosure. FIG. 13 is a schematic diagram showing the flow direction of the cooling fluid on the first surface of the liquid cooling module according to the fourth embodiment of the present disclosure. In the embodiment, the structures, elements and functions of the heat dissipation assembly 1c and the liquid cooling module 3c are similar to those of the heat dissipation assembly 1, 1a and the liquid cooling modules 3, 3a of FIG. 1 to FIG. 6, and are not redundantly described herein. Please refer to FIG. 6, FIG. 7, FIG. 12 and FIG. 13. In the embodiment, the present disclosure provides a heat dissipation assembly 1c includes an elongated liquid cooling module 3c and a plurality of electronic devices 9a, 9b, 9c. The liquid cooling module 3c includes an elongated housing base 2c, a top cover 40 and a bottom cover 30. In the embodiment, the housing base 2c has a first lateral side 11, a second lateral side 12, a third lateral side 13, a fourth lateral side 14, a first surface 101 and a second surface 102. The first lateral side 11 and the second lateral side 12 are elongated lateral sides and opposite to each other. Preferably but not exclusively, the first lateral side 11 and the second lateral side 12 are extended along a first direction, such as the Y axial direction. The third lateral side 13 and the fourth lateral side 14 are short lateral sides opposite to each other, and connected between the first lateral side 11 and the second lateral side 12, respectively. In addition, the first surface 101 and the second surface 102 are the bottom side and the top side of the housing base 2c, respectively, which are two sides opposite to each other. In the embodiment, the distance between the first lateral side 11 and the second lateral side 12 is smaller than the distance between the third lateral side 13 and the fourth lateral side 14. That is, the length of the elongated lateral sides of the first lateral side 11 and the second lateral side 12 is greater than the length of the short lateral sides of the third lateral side 13 and the fourth lateral side 14, so as to form a long and narrow rectangular housing base 2c. In the embodiment, the integrated housing base 2c includes an inflow chamber 21, an outflow chamber 22, a plurality of manifold chambers 41a, 41b, 41c, a partition wall 20, a plurality of first through holes 23a, 23b, 23c, a plurality of second through holes 24a, 24b, 24c, at least one diversion structure 25a, 25b, a cooling-flow-channel inlet 31 and a cooling-flow-channel outlet 32. The inflow chamber 21 is disposed on the first surface 101, and spatially corresponding to the first lateral side 11 and the third lateral side 13. The outflow chamber 22 is disposed on the first surface 101, and spatially corresponding to the second lateral side 12 and the fourth lateral side 14. The partition wall 20 is disposed between the inflow chamber 21 and the outflow chamber 22. In the embodiment, one end of the partition wall 20 is connected to the third lateral side 13 and close to the second lateral side 12, and the other end of the partition wall 20 is connected to the fourth lateral side 14 and close to the first lateral side 11. Notably, in the embodiment, one side of the bottom cover 30 is assembled with the first lateral side 11, the second lateral side 12, the third lateral side 13 and the fourth lateral side 14 of the housing base 2c, and connected to the partition wall 20, so as to form the inflow chamber 21 and the outflow channel 22. The cooling-flow-channel inlet 31 and the cooling-flow-channel outlet 32 pass through the bottom cover 30 and are disposed on the bottom cover 30. Moreover, in the embodiment, the cooling-flow-channel inlet 31 is disposed adjacent to the third lateral side 13 and in fluid communication with the inflow chamber 21. The cooling-flow-channel outlet 32 is disposed adjacent to the fourth lateral side 14 and in fluid communication with the outflow chamber 22. Certainly, in the present disclosure, the assembling method of the bottom cover 30 and the housing base 2c is not limited thereto. Notably, after the bottom cover 30 is assembled with the elongated housing base 2c, the space on the first surface 101 is divided into the inflow chamber 21 and the outflow chamber 22 by the partition wall 20. Preferably but not exclusively, the inflow chamber 21 and the outflow chamber 22 are symmetrical to each other. Preferably but not exclusively, in the embodiment, the top cover 40 and the housing base 2c of the liquid cooling module 3c are assembled with each other to form the plurality of manifold chamber 41a, 41b, 41c. The top cover 40 includes a top side and a bottom side opposite to each other. In the embodiment, the heat dissipation surface 43 corresponding to the electronic devices 9a, 9b, 9c is disposed on the top side of the top cover 40, and the bottom side of the top cover 40 is assembled with the first lateral side 11, the second lateral side 12, the third lateral side 13, the fourth lateral side 14 and the second surface 102 of the housing base 3c, so as to form the plurality of manifold chambers 41a, 41b, 41c. Certainly, in the present disclosure, the assembling method of the top cover 40 and the housing base 2c is not limited thereto, and not redundantly described herein.

Preferably but not exclusively, the plurality of fins 42 are disposed on the bottom side of the top cover 40, accommodated in the plurality of manifold chambers 41a, 41b, 41c, and extended from the bottom side of the top cover 40 toward the second surface 102. Preferably but not exclusively, in other embodiments, the plurality of fins 42 are disposed on the second surface 102, connected to the top cover 40, and thermally coupled to the heat dissipation surface 40 on the top side. Certainly, the present disclosure is not limited thereto. By assembling the top cover 40 and the housing base 2c, the plurality of manifold chambers 41a, 41b, 41c are disposed on the second surface 102 , and thermally coupled to the plurality of fins 42. Furthermore, the plurality of fins 42 are connected to the heat dissipation surface 43 to dissipate heat from the plurality of electronic devices 9a, 9b, 9c thereon.

In the embodiment, the plurality of first through holes 23a, 23b, 23c are disposed adjacent to the first lateral side 11, arranged along the first direction (i.e., the Y axial direction), and in fluid communication between the inflow chamber 21 and the plurality of manifold chambers 41a, 41b, 41c, respectively. The plurality of second through holes 24a, 24b, 24c are disposed adjacent to the second lateral side 12, arranged along the first direction (i.e., the Y axial direction), and in fluid communication between the outflow chamber 22 and the plurality of manifold chambers 41a, 41b, 41c. In the embodiment, the plurality of manifold chambers 41a, 41b, 41c correspond to the plurality of first through holes 23a, 23b, 23c adjacent to the first lateral side 11, and correspond to the plurality of second through holes 24a, 24b, 24c adjacent to the second lateral side 12. The respective numbers of the plurality of manifold chambers 41a, 41b, 41c, the plurality of first through holes 23a, 23b, 23c and the plurality of second through holes 24a, 24b, 24c are equal to three. The manifold chamber 41a, the first thorough hole 23a and the second through hole 24a are cooperated to form a flow channel F1 correspondingly. The manifold chamber 41b, the first through hole 23b and the second through hole 24b are cooperated to form a flow channel F2 correspondingly. The manifold chamber 41c, the first through hole 23c and the second through hole 24c are cooperated to formed a flow channel F3 correspondingly. The three flow channels F1, F2, F3 are connected in parallel between the inflow chamber 21 and the outflow chamber 22, and the flow direction of the three flow channels F1, F2, F3 is perpendicular to the first direction (i.e., the Y axial direction) and parallel to X axial direction.

In the embodiment, the diversion structures 25a, 25b are disposed on the first surface 101 and located in the inflow chamber 21. The diversion structures 25a, 25b have first ends connected to the partition wall 20, and second ends extended along the second direction parallel to the X axial direction. The second direction is perpendicular to the first direction. Thereby, the diversion structure 25a provides the diversion function for the adjacent two first through holes 23a, 23b. The diversion structure 25b provides the diversion function for the adjacent two first through holes 23b, 23c. In the present disclosure, with the arrangement of the diversion structures 25a, 25b, it allows the parallel flow channels F1, F2, F3 to achieve a uniform flow rate and meet the heat dissipation requirements of the plurality of electronic devices 9a, 9b, 9c arranged in one single direction.

Preferably but not exclusively, in the embodiment, the plurality of electronic devices 9a, 9b, 9c are three power devices used in a multi-phase inverter and configured to output the driving current of the motor. Since each power device needs to have its own input and output electrical connections, it needs to be arranged in a single direction and electrically connected to the outside on both elongated lateral sides of the heat dissipation assembly 1c. In order to meet the heat dissipation requirements of the plurality of electronic devices 9a, 9b, 9c arranged in one single direction, the heat dissipation assembly 1c has the plurality of electronic devices 9a, 9b, 9c disposed on the heat dissipation surface 43, arranged along the first direction (i.e., the Y axial direction), and thermally coupled to the plurality of fins 42. In case of that the plurality of electronic devices 9a, 9b, 9c are served as the power devices of the aforementioned multi-phase inverter, the electronic devices 9a, 9b, 9c can be electrically connected to the outside via the first lateral side 11 or the second lateral side 12. Certainly, the present disclosure is not limited thereto. In the embodiment, after a cooling fluid is introduced into the inflow chamber 21 through the cooling-flow-channel inlet 31, the cooling fluid is evenly divided into the plurality of first through holes 23a, 23b, 23c through the diversion function of the diversion structures 25a, 25b in the inflow chamber 21, and enters the plurality of manifold chambers 41a, 41b, 41c, respectively. The cooling fluid in the plurality of manifold chamber 41a, 41b, 41c exchanges heat with the plurality of fins 42 to dissipate heat from the plurality of electronic devices 9a, 9b, 9c. Thereafter, the cooling fluid in the plurality of manifold chambers 41a, 41b, 41c flows to the outflow chamber 22 through the confluence in the plurality of second through holes 24a, 24b, 24c respectively. Finally, the cooling fluid is discharged out of the outflow chamber 22 through the cooling channel outlet 32.

In the embodiment, the plurality of manifold chambers 41a, 41b, 41c correspond to the first through holes 23a, 23b, 23c adjacent to the first lateral side 11, and correspond to the second through holes 24a, 24b, 24c adjacent to the second lateral side 12, so that a plurality of transverse flow channels F1, F2, F3 are formed. Through the diversion function of the diversion structures 25a, 25b, the plurality of transverse flow channels F1, F2, F3 are connected in parallel between the inflow chamber 21 and the outflow chamber 22. In that, the cooling fluid with equal flow rate is evenly divided to dissipate the heat from the plurality of electronic devices 9a, 9b, 9c, respectively. Notably, the flow direction of the plurality of transverse flow channels F1, F2, F3 is perpendicular to the elongated lateral sides, that is, the extended direction of the first lateral side 11 and the second lateral side 12. The flow direction is not designed to extend along the elongated lateral sides, but is designed in a short path, so that the cooling fluid flows through the transverse flow channels F1, F2, F3 of the plurality of manifold chambers 41a, 41b, 41c in the shortest path of the elongated housing base 2c. It helps to reduce the length of the flow channels and improve the uniform heat dissipation performance. In this way, the cooling-flow-channel inlet 31 and the cooling- flow-channel outlet 32 can be arranged at different ends of the elongated lateral side. Preferably but not exclusively, the cooling-flow-channel inlet 31 and the cooling- flow-channel outlet 32 are arranged adjacent to the third lateral side 13 and the fourth lateral side 14, respectively . In the embodiment, the plurality of first through holes 23a, 23b, 23c and the plurality of second through holes 24a, 24b, 24c are all slotted holes, which are extended along the first direction (i.e., the Y axial direction). Moreover, the plurality of first through holes 23a, 23b, 23c, the plurality of second through holes 24a, 24b, 24c and the plurality of manifold chambers 41b, 41c have an identical width W in view of the first direction. The plurality of flow channels F1, F2, F3 are formed and cooperated with the diversion structures 25a, 25b to achieve the even diversion, so that the plurality of electronic devices 9a, 9b, 9c corresponding to the plurality of manifold chambers 41a, 41b, 41c in the heat dissipation assembly 1c have similar heat dissipation conditions, which can quickly and evenly take away the heat generated by the plurality of electronic devices 9a, 9b, 9c. Thus, the overall heat dissipation efficiency is improved effectively.

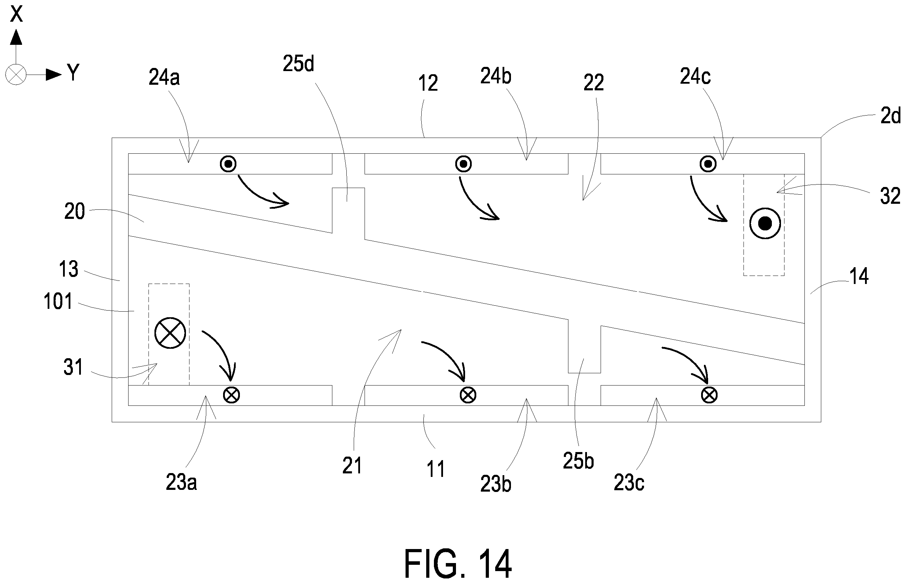

Notably, in the embodiment, the diversion structures 25a, 25b are, for example, in the shape of a long rectangle, and the extension length in the second direction (i.e., the X axial direction) is adjustable according to the practical requirements. In other embodiments, one of the diversion structures 25a, 25b is omitted, and the cooling fluid flowing can still be uniformly divided, so that the parallel flow channels F1, F2, F3 achieve a uniform flow rate and meet the heat dissipation requirements of the plurality of electronic devices 9a, 9b, 9c arranged in the single direction. FIG. 14 illustrates a second example of the diversion structures for the liquid cooling module of the present disclosure. In the embodiment, the structures, elements and functions of the housing base 2d are similar to those of the housing base 2c of FIG. 12 to FIG. 13, and are not redundantly described herein. Please refer to FIG. 6, and FIG. 12 to FIG. 14. In the embodiment, the housing base 2d includes a diversion structure 25b and a diversion structure 25d. The diversion structure 25b and the diversion structure 25d are located in the inflow chamber 21 and the outflow chamber 22, respectively. The diversion structure 25b located in the inflow chamber 21 has one end connected to the partition wall 20 and the other end extended toward the first lateral side 11 in the second direction (i.e., the X axial direction). In that, the diversion structure 25b provides the diversion function for the adjacent two first through holes 23b, 23c, and is helpful to uniform the flow of the flow channels F2, F3. The diversion structure 25d located in the outflow chamber 22 has one end connected to the partition wall 20 and the other end extended toward the second lateral side 12 in the second direction (i.e., the X axial direction). In that, the diversion structure 25d provides the diversion function for the adjacent two second through holes 24a, 24b, and is helpful to uniform the flow of the flow channels F1, F2. With the arrangement of the diversion structures 25b, 25d, it helps the parallel flow channels F1, F2, F3 to achieve a uniform flow rate and meet the heat dissipation requirements of the plurality of electronic devices 9a, 9b, 9c arranged in one single direction.

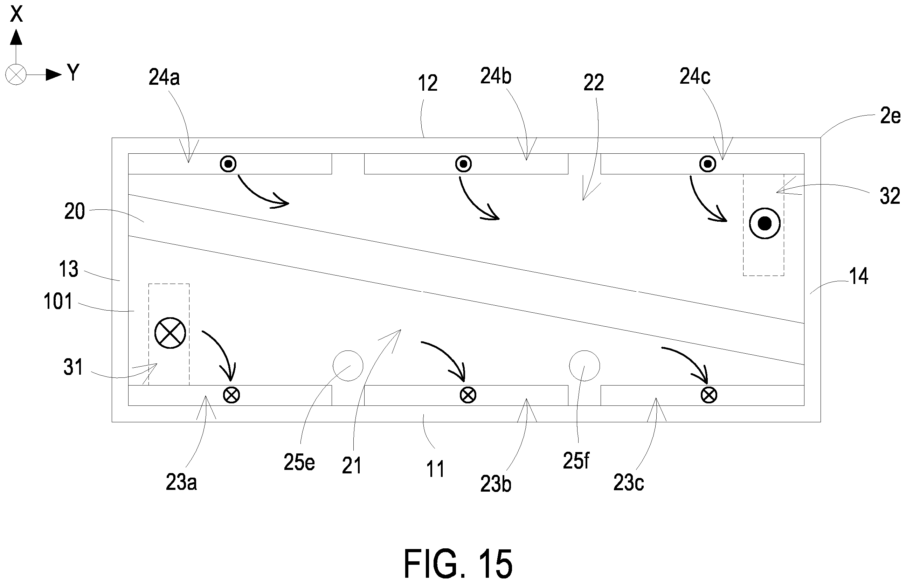

FIG. 15 illustrates a third example of the diversion structures for the liquid cooling module of the present disclosure. In the embodiment, the structures, elements and functions of the housing base 2e are similar to those of the housing base 2c of FIG. 12 to FIG. 13, and are not redundantly described herein. Please refer to FIG. 6, FIG. 12, FIG. 13 and FIG. 15. In the embodiment, the housing base 2e includes a diversion structure 25e and a diversion structure 25f. The diversion structures 25e, 25f are both disposed in the inflow chamber 21, but are not connected to the partition wall 20. In the embodiment, the diversion structures 25e, 25f are both circular in shape. Preferably but not exclusively, the diversion structure 25e is located on a midline between the adjacent two first through holes 23a, 23b, and the diversion structure 25f is located on a midline between the adjacent two first through holes 23b, 23c. In other embodiments, the diversion structure 25e is disposed in the outflow chamber 22, and located on a midline between the adjacent two second through holes 24a, 24b, or the diversion structure 25f is disposed in the outflow chamber 22 and located on a midline between the adjacent two second through holes 24b, 24c. Certainly, the arrangement of the diversion structures 25e, 25f is adjustable according to the practical requirements, and the present disclosure is not limited thereto. With the arrangement of the diversion structures 25e, 25f, it helps the parallel flow channels F1, F2, F3 to achieve a uniform flow rate and meet the heat dissipation requirements of the plurality of electronic devices 9a, 9b, 9c arranged in one single direction.

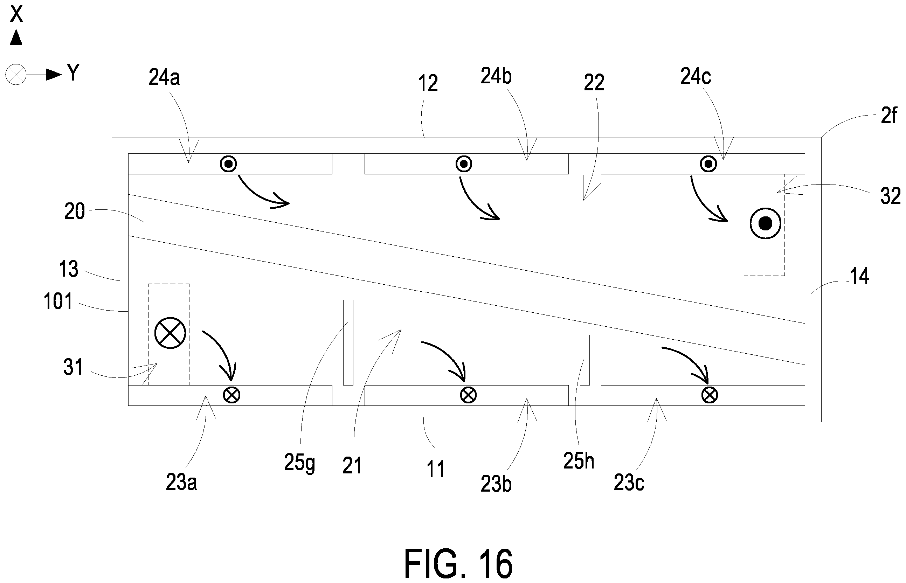

FIG. 16 illustrates a fourth example of the diversion structures for the liquid cooling module of the present disclosure. In the embodiment, the structures, elements and functions of the housing base 2f are similar to those of the housing base 2c of FIG. 12 to FIG. 13, and are not redundantly described herein. Please refer to FIG. 6, FIG. 12, FIG. 13 and FIG. 16. In the embodiment, the housing base 2f includes a diversion structure 25g and a diversion structure 25h. The diversion structures 25g, 25h are both disposed in the inflow chamber 21, but are not connected to the partition wall 20. Moreover, the diversion structures 25g, 25h are connected to the first surface 101 or the bottom cover 30, merely. In the embodiment, the diversion structures 25g, 25h are in an elongated strip shape and spaced apart from the partition wall 20. The diversion structure 25g is extended along a midline between the adjacent two first through holes 23a, 23b, and the diversion structure 25h is extended along a midline between the adjacent two first through holes 23b, 23c. In other words, the diversion structures 25g, 25h are extended along the second direction (i.e., the X axial direction), and perpendicular to the first direction. With the arrangement of the diversion structures 25g, 25h, it helps the parallel flow channels F1, F2, F3 to achieve a uniform flow rate and meet the heat dissipation requirements of the plurality of electronic devices 9a, 9b, 9c arranged in one single direction. Certainly, the arrangement of the diversion structures 25g, 25h is adjustable according to the practical requirements, and the present disclosure is not limited thereto.

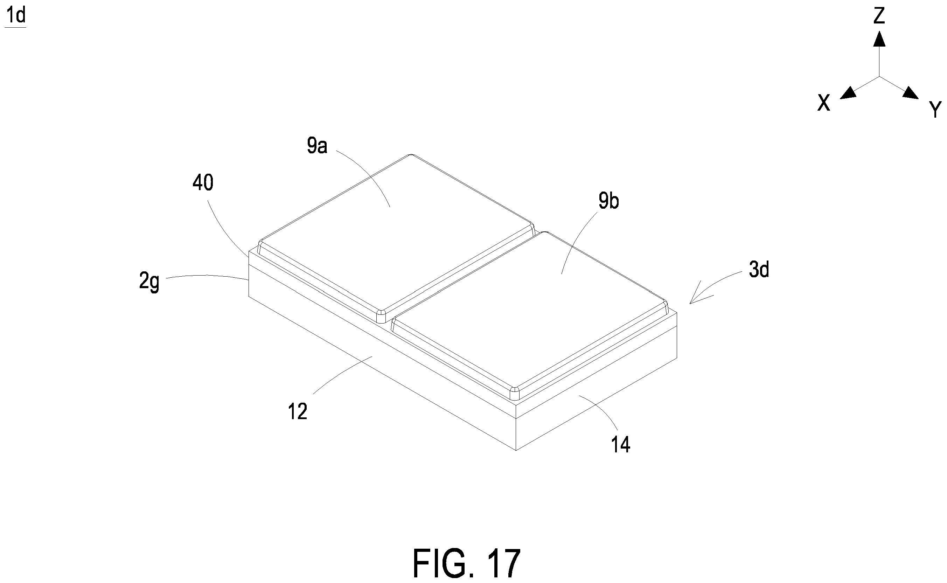

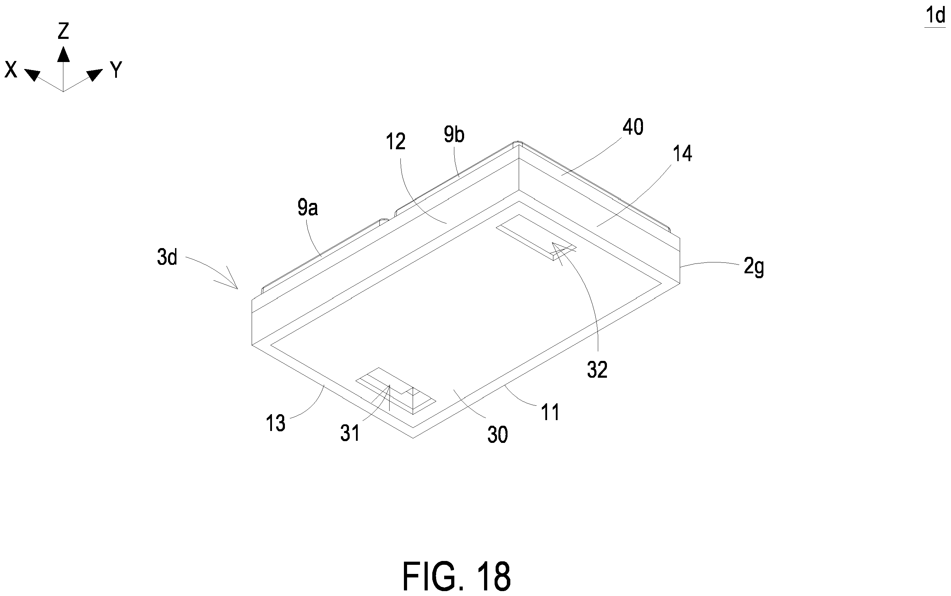

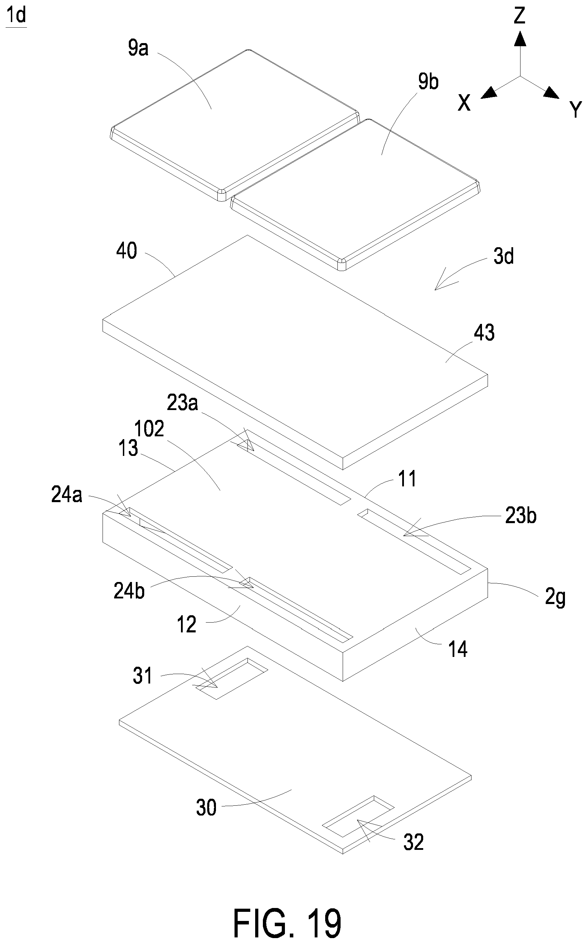

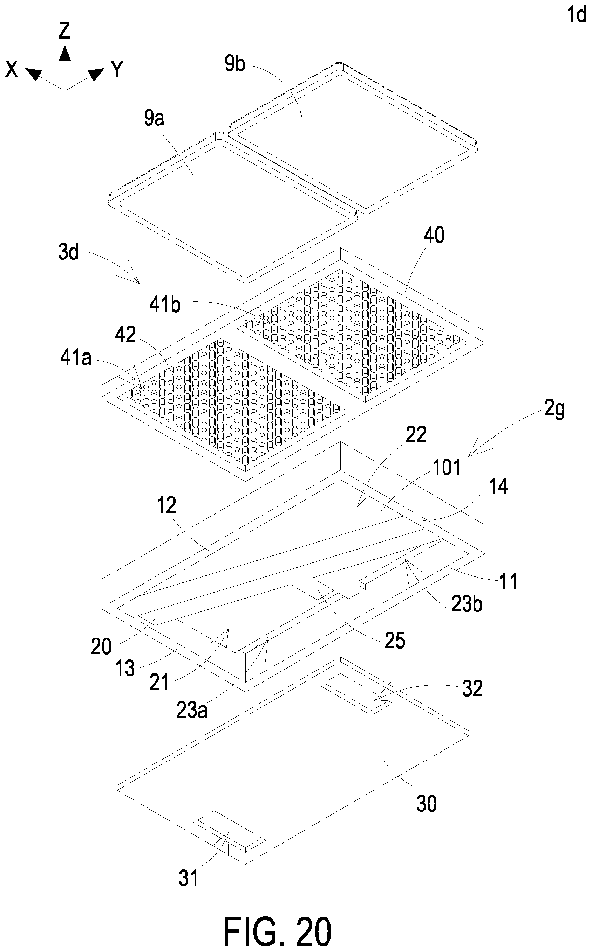

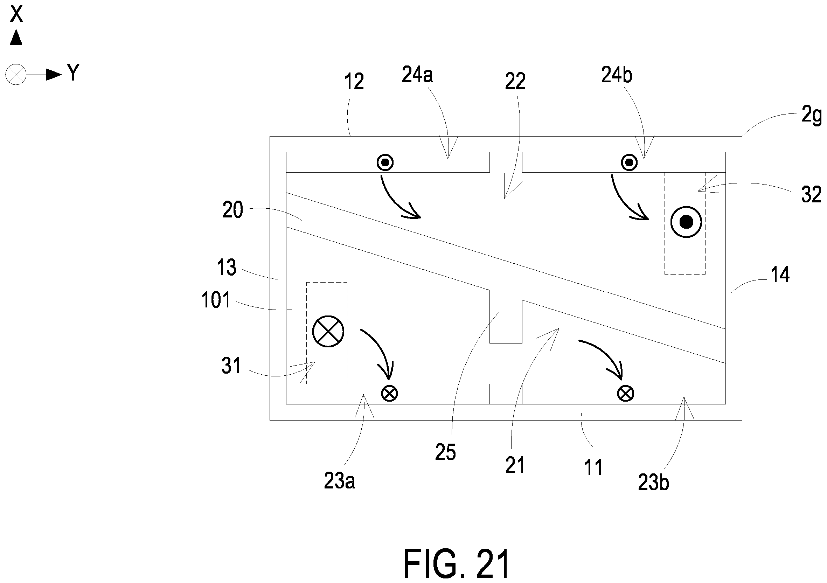

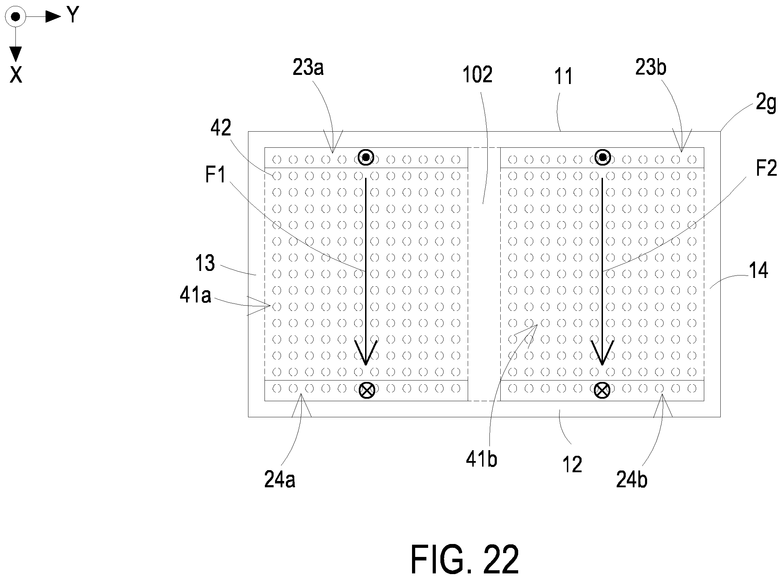

FIG. 17 and FIG. 18 are perspective structural views illustrating a heat dissipation assembly according to a fifth embodiment of the present disclosure. FIG. 19 and FIG. 20 are exploded views illustrating the heat dissipation assembly according to the fifth embodiment of the present disclosure. FIG. 21 is a schematic diagram showing the flow direction of the cooling fluid on the first surface of the liquid cooling module according to the fifth embodiment of the present disclosure. FIG. 22 is a schematic diagram showing the flow direction of the cooling fluid on the second surface of the liquid cooling module according to the fifth embodiment of the present disclosure. In the embodiment, the structures, elements and functions of the heat dissipation assembly 1d and the liquid cooling module 3d are similar to those of the heat dissipation assembly 1c and the fluid cooling module 3c of FIG. 12 to FIG. 13, and are not redundantly described herein. In the embodiment, the heat dissipation assembly 1d includes an elongated liquid cooling module 3d and at least two electronic devices 9a, 9b. The housing base 2g of the liquid cooling module 3d includes at least two manifold chambers 41a, 41b, at least two first through holes 23a, 23b, at least two second through holes 24a, 24b and at least one diversion structure 25. Notably, the manifold chambers 41a, 41b, the first through holes 23a, 23b, and the second through holes 24a, 24b correspond to each other and are equal in number, and equal to the number of the electronic devices 9a, 9b. In other embodiments, the manifold chambers 41a, 41b, the first through holes 23a, 23b, the second through holes 24a, 24b and the electronic devices 9a, 9b are equal in number of M, M is an integer, and M≧2. In other words, the manifold chambers 41a, 41b, the first through holes 23a, 23b and the second through holes 24a, 24b are correspondingly cooperated to form M flow channels F1, F2, and the M flow channels F1, F2 have a flow direction perpendicular to the first direction (i.e., the Y axial direction). In an embodiment, the number of diversion structures 25 is N, N is an integer, N ≧ 1, especially N+1=M is preferred.

In the embodiment, the diversion structure 25 is disposed on the first surface 101, located in the inflow chamber 21, and connected to the partition wall 20, so as to provide the diversion function for each adjacent two first through holes 23a, 23b. In other embodiments, the diversion structure 25 is located in the inflow chamber 21 or the outflow chamber 22, or spaced apart from the partition wall 20, so as to provide the diversion function for each adjacent two first through holes 23a, 23b or each adjacent two second through holes 24a, 24b. Through the diversion function of the diversion structure 25, the plurality of transverse flow channels F1, F2 are connected in parallel between the inflow chamber 21 and the outflow chamber 22. In that, the cooling fluid with equal flow rate is evenly divided to dissipate the heat from the plurality of electronic devices 9a, 9b, respectively. Notably, the flow direction of the plurality of transverse flow channels F1, F2 is perpendicular to the extended direction of the first lateral side 11 and the second lateral side 12, so that the cooling fluid flows through the transverse flow channels F1, F2 of the plurality of manifold chambers 41a, 41b in the shortest path of the elongated housing base 2g. It helps to reduce the length of the flow channels and improve the uniform heat dissipation performance. In this way, the cooling fluid is introduced into the inflow chamber 21 through the cooling-flow-channel inlet 31 adjacent to the third lateral side 13, and evenly divided into the plurality of flow channels F1, F2 through the diversion structure 25. That is, the plurality of electronic devices 9a, 9b corresponding to the plurality of manifold chambers 41a, 41b, in the heat dissipation assembly 1d have similar heat dissipation conditions, which can quickly and evenly take away the heat generated by the plurality of electronic devices 9a, 9b. Thus, the overall heat dissipation efficiency is improved effectively. Certainly, the number of the diversion structure 25 corresponding to that of the manifold chambers 41a, 41b, the first through holes 23a, 23b, the second through holes 24a, 24b and the electronic devices 9a, 9b is adjustable according to the practical requirements. The present disclosure is not limited thereto and not redundantly described hereafter.

In summary, the present disclosure provides a liquid cooling module and a heat dissipation assembly using the same. By introducing a diversion structure into plural parallel flow channels, the temperature difference of the plural electronic devices and the flow impedance of the cooling fluid in the heat dissipation assembly are reduced effectively. In order to meet the heat dissipation requirements of plural electronic devices arranged in a single direction, the liquid cooling module provides a parallel flow channel design in an elongated housing base. The top side of the housing base is divided into a plurality of diversion chambers, which is connected to heat dissipation fins thermally coupled with a plurality of electronic devices. The bottom side of the housing base is divided into an inflow chamber and an outflow chamber through a partition wall. Furthermore, by disposing at least one diversion structure, the cooling fluid entering the inflow chamber is evenly divided into equal portions and then enters a plurality of diversion chambers through a plurality of through holes disposed adjacent to the elongated lateral side. Then, the cooling fluid is converged into the outflow chamber through a plurality of through holes disposed on the opposite elongated lateral side, so as to discharge the cooling fluid out of the heat dissipation assembly. The plurality of manifold chambers correspond to the plurality of through holes on both elongated lateral sides to form a plurality of transverse flow channels. The plurality of transverse flow channels are connected between the inflow chamber and the outflow chamber in parallel, and has the cooling fluid flowing through with an equal flowrate, so as to dissipate the heat from the plurality of electronic devices, respectively. Since the flow direction of the plurality of transverse flow channels is perpendicular to the extension direction of the elongated lateral sides rather than along the extension direction of the elongated lateral side, a short path design is adopted, so that the transverse flow channels of the plurality of manifold chambers are located between two opposite elongated lateral sides of the elongated housing base. It helps to reduce the length of the flow channels and improve the uniform heat dissipation performance. Thereby, the cooling-flow-channel inlet and the cooling-flow-channel outlet can be disposed at different ends of the elongated lateral side, respectively. Furthermore, the through holes extended along the two opposite elongated lateral sides and the manifold chambers connected therebetween have the same width, and the cooling fluid flowing through the plurality of flow channels formed can be uniformly divided by at least one diversion structure, so that the plurality of electronic devices corresponding to the plurality of manifold chambers in the heat dissipation assembly have similar heat dissipation conditions, which can quickly and evenly take away the heat generated by the plurality of electronic devices. Thus, the overall heat dissipation efficiency is improved effectively.

## Claims

1. A liquid cooling module (3, 3, 3b, 3c, 3d) **characterized by** comprising:
a housing base (2, 2a, 2b, 2c, 2d, 2e, 2f, 2g) having a first lateral side (11), a second lateral side (12), a third lateral side (13), a fourth lateral side (14), a first surface (101) and a second surface (102), wherein the first lateral side (11) and the second lateral side (12) are opposite to each other and extended along a first direction; and the housing base (2, 2a, 2b, 2c, 2d, 2e, 2f, 2g) comprises:
an inflow chamber (21) disposed on the first surface (101);
an outflow chamber (22) disposed on the first surface (101);
a plurality of manifold chambers (41, 41b, 41c) disposed on the second surface (102) and configured to be thermally coupled with a plurality of fins (42);
a partition wall (20, 20a) disposed between the inflow chamber (21) and the outflow chamber (22);
a plurality of first through holes (23a, 23b, 23c) disposed adjacent to the first lateral side (11), arranged along the first direction, and in fluid communication between the inflow chamber (21) and the plurality of manifold chambers (41, 41b, 41c), respectively;
a plurality of second through holes (24a, 24b, 24c) disposed adjacent to the second lateral side (12), arranged along the first direction, and in fluid communication between the outflow chamber (22) and the plurality of manifold chambers (41, 41b, 41c), wherein the plurality of manifold chambers (41, 41b, 41c) correspond to the plurality of first through holes (23a, 23b, 23c) adjacent to the first lateral side (11), and correspond to the plurality of second through holes (24a, 24b, 24c) adjacent to the second lateral side (12); and
at least one diversion structure (25, 25a, 25b, 25c, 25d, 25e, 25f, 25g, 25h, 33a, 33b) located in the inflow chamber (21) or the outflow chamber (22), or connected to the partition wall (20, 20a), to perform a diversion function, wherein a cooling fluid enters the plurality of manifold chambers (41, 41b, 41c) from the inflow chamber (21) through the plurality of first through holes (23a, 23b, 23c), respectively, to exchange heat with the plurality of fins (42), and then the cooling fluid flows into the outflow chamber (22) from the plurality of manifold chambers (41, 41b, 41c) through the plurality of second through holes (24a, 24b, 24c), respectively, to discharge.

2. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is disposed on the first surface (101) and protrudes toward the inflow chamber (21) or the outflow chamber (22).

3. The liquid cooling module (3, 3, 3b, 3c, 3d) according to claim 1, further comprising a bottom cover (30), wherein the bottom cover (30) is assembled with the first lateral side (11), the second lateral side (12), the third lateral side (13), the fourth lateral side (14) and the first surface (101), and connected to the partition wall (20, 20a) to form the inflow chamber (21) and the outflow chamber (22), wherein the at least one diversion structure (25, 25a, 25b, 25c, 25d, 25e, 25f, 25g, 25h, 33a, 33b) is disposed on the bottom cover (30) and protrudes toward the inflow chamber (21) or the outflow chamber (22).

4. The liquid cooling module (3, 3, 3b, 3c, 3d) according to claim 3, wherein the liquid cooling module (3, 3, 3b, 3c, 3d) further comprises:
a cooling-flow-channel inlet (31) passing through and disposed on the bottom cover (30) and in fluid communication with the inflow chamber (21); and
a cooling-flow-channel outlet (32) passing through and disposed on the bottom cover (30) and in fluid communication with the outflow chamber (22).

5. The liquid cooling module (3, 3, 3b, 3c, 3d) according to claim 1, wherein the liquid cooling module (3, 3, 3b, 3c, 3d) further comprises:
a cooling-flow-channel inlet (31) disposed adjacent to the third lateral side (13) and in fluid communication with the inflow chamber (21); and
a cooling-flow-channel outlet (32) disposed adjacent to the fourth lateral side (14) and in fluid communication with the outflow chamber (22).

6. The liquid cooling module (3, 3, 3b, 3c, 3d) according to claim 5, further comprising a bottom cover (30), wherein the bottom cover (30) is assembled with the first lateral side (11), the second lateral side (12), the third lateral side (13), the fourth lateral side (14) and the first surface (101), and connected to the partition wall (20, 20a) to form the inflow chamber (21) and the outflow chamber (22), wherein the cooling-flow-channel inlet (31) and the cooling-flow-channel outlet (32) pass through the bottom cover (30) and are disposed on the bottom cover (30).

7. The liquid cooling module (3, 3, 3b, 3c, 3d) according to claim 1, wherein the at least one diversion structure (25, 25a, 25b, 25c, 25d, 25e, 25f, 25g, 25h, 33a, 33b) has a first end connected to the partition wall (20, 20a) and a second end extended along a second direction, and the second direction is perpendicular to the first direction.

8. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is circular in shape and located on a midline between each adjacent two of the plurality of first through holes (23a, 23b, 23c) or on a midline between each adjacent two of the plurality of second through holes (24a, 24b, 24c) to provide the diversion function.

9. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is in an elongated strip shape, spaced apart from the partition wall (20, 20a), and extended along a second direction, and the second direction is perpendicular to the first direction.

10. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is formed by irregular bending of the partition wall (20, 20a).

11. The liquid cooling module (3, 3, 3b, 3c, 3d) according to claim 1, wherein the plurality of first through holes (23a, 23b, 23c) and the plurality of second through holes (24a, 24b, 24c) are slotted holes extended along the first direction.

12. The liquid cooling module (3, 3, 3b, 3c, 3d) according to claim 1, further comprising a top cover (40), wherein the top cover (40) has a top side and a bottom side opposite to each other, the bottom side is assembled with the first lateral side (11), the second lateral side (12), the third lateral side (13), the fourth lateral side (14) and the second surface (102) of the housing base (2, 2a, 2b, 2c, 2d, 2e, 2f, 2g) to form the plurality of manifold chambers (41, 41b, 41c), the plurality of fins (42) are accommodated in the plurality of manifold chambers (41, 41b, 41c) and extended from the bottom side toward the second surface (102), and a heat dissipation surface (43) is disposed on the top side and thermally coupled with the plurality of fins (42).

13. The liquid cooling module (3, 3, 3b, 3c, 3d) according to claim 1, wherein the plurality of manifold chambers (41, 41b, 41c), the plurality of first through holes (23a, 23b, 23c) and the plurality of second through holes (24a, 24b, 24c) are equal in number of M, M is an integer, and M≧2.

14. The liquid cooling module (3, 3, 3b, 3c, 3d) according to claim 1, wherein the plurality of manifold chambers (41, 41b, 41c), the plurality of first through holes (23a, 23b, 23c) and the plurality of second through holes (24a, 24b, 24c) are correspondingly cooperated to form M flow channels (F1, F2, F3), and the M flow channels (F1, F2, F3) have a flow direction perpendicular to the first direction.

15. A heat dissipation assembly (1, 1a, 1b, 1c, 1d) **characterized by** comprising:
a liquid cooling module (3, 3, 3b, 3c, 3d) comprising a housing base (2, 2a, 2b, 2c, 2d, 2e, 2f, 2g) and a bottom cover (30), wherein the housing base (2, 2a, 2b, 2c, 2d, 2e, 2f, 2g) has a first lateral side (11), a second lateral side (12), a third lateral side (13), a fourth lateral side (14), a first surface (101) and a second surface (102), the first lateral side (11) and the second lateral side (12) are opposite to each other and extended along a first direction, the bottom cover (30) is spatially corresponding to the first surface (101) and connected to the first lateral side (11), the second lateral side (12), the third lateral side (13) and the fourth lateral side (14), and the housing base (2, 2a, 2b, 2c, 2d, 2e, 2f, 2g) comprises:
an inflow chamber (21) disposed between the first surface (101) and the bottom cover (30);
an outflow chamber (22) disposed between the first surface (101) and the bottom cover (30);
a plurality of manifold chambers (41, 41b, 41c) disposed on the second surface (102) and configured to be thermally coupled with a plurality of fins (42);
a partition wall (20, 20a) disposed between the inflow chamber (21) and the outflow chamber (22) and connected between the first surface (101) and the bottom cover (30);
a plurality of first through holes (23a, 23b, 23c) disposed adjacent to the first lateral side (11), arranged along the first direction, and in fluid communication between the inflow chamber (21) and the plurality of manifold chambers (41, 41b, 41c), respectively;
a plurality of second through holes (24) disposed adjacent to the second lateral side (12), arranged along the first direction, and in fluid communication between the outflow chamber (22) and the plurality of manifold chambers (41, 41b, 41c), wherein the plurality of manifold chambers (41, 41b, 41c) correspond to the plurality of first through holes (23a, 23b, 23c) adjacent to the first lateral side (11), and correspond to the plurality of second through holes (24a, 24b, 24c) adjacent to the second lateral side (12); and
at least one diversion structure (25, 25a, 25b, 25c, 25d, 25e, 25f, 25g, 25h, 33a, 33b) disposed on the bottom cover (30) or the first surface (101), and protruding toward the inflow chamber (21) or the outflow chamber (22), to perform a diversion function, wherein a cooling fluid enters the plurality of manifold chambers (41, 41b, 41c) from the inflow chamber (21) through the plurality of first through holes (23a, 23b, 23c), respectively, to exchange heat with the plurality of fins (42), and then the cooling fluid flows into the outflow chamber (22) from the plurality of manifold chambers (41, 41b, 41c) through the plurality of second through holes (24a, 24b, 24c), respectively, to discharge.

## Amended claims

### Amended claims in accordance with Rule 137(2) EPC.

1. A liquid cooling module (3, 3, 3b, 3c, 3d) comprising:
a housing base (2, 2a, 2b, 2c, 2d, 2e, 2f, 2g) having a first lateral side (11), a second lateral side (12), a third lateral side (13), a fourth lateral side (14), a first surface (101) and a second surface (102), wherein the first lateral side (11) and the second lateral side (12) are opposite to each other and extended along a first direction;
a top cover (40) assembling with the first lateral side (11), the second lateral side (12), the third lateral side (13), the fourth lateral side (14) and the second surface (102); and
a bottom cover (30) assembling with the first lateral side (11), the second lateral side (12), the third lateral side (13), the fourth lateral side (14) and the first surface (101), **characterized in that**:
the housing base (2, 2a, 2b, 2c, 2d, 2e, 2f, 2g) comprises:
an inflow chamber (21) disposed on the first surface (101);
an outflow chamber (22) disposed on the first surface (101);
a plurality of manifold chambers (41, 41b, 41c) disposed between the top cover and the second surface (102) and configured to be thermally coupled with a plurality of fins (42);
a partition wall (20, 20a) disposed between the inflow chamber (21) and the outflow chamber (22);
a plurality of first through holes (23a, 23b, 23c) disposed adjacent to the first lateral side (11), arranged along the first direction, and in fluid communication between the inflow chamber (21) and the plurality of manifold chambers (41, 41b, 41c), respectively;
a plurality of second through holes (24a, 24b, 24c) disposed adjacent to the second lateral side (12), arranged along the first direction, and in fluid communication between the outflow chamber (22) and the plurality of manifold chambers (41, 41b, 41c), wherein the plurality of manifold chambers (41, 41b, 41c) correspond to the plurality of first through holes (23a, 23b, 23c) adjacent to the first lateral side (11), and correspond to the plurality of second through holes (24a, 24b, 24c) adjacent to the second lateral side (12); and
at least one diversion structure (25, 25a, 25b, 25c, 25d, 25e, 25f, 25g, 25h, 33a, 33b) located in the inflow chamber (21) or the outflow chamber (22), or connected to the partition wall (20, 20a), arranged along a second direction, to perform a diversion function, and the second direction is perpendicular to the first direction, wherein a cooling fluid enters the plurality of manifold chambers (41, 41b, 41c) from the inflow chamber (21) through the plurality of first through holes (23a, 23b, 23c), respectively, to exchange heat with the plurality of fins (42), and then the cooling fluid flows into the outflow chamber (22) from the plurality of manifold chambers (41, 41b, 41c) through the plurality of second through holes (24a, 24b, 24c), respectively, to discharge.

2. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is disposed on the first surface (101) and protrudes toward the inflow chamber (21) or the outflow chamber (22).

3. The liquid cooling module (3, 3, 3b, 3c, 3d) according to claim 1, the bottom cover (30) is connected to the partition wall (20, 20a) to form the inflow chamber (21) and the outflow chamber (22), wherein the at least one diversion structure (25, 25a, 25b, 25c, 25d, 25e, 25f, 25g, 25h, 33a, 33b) is disposed on the bottom cover (30) and protrudes toward the inflow chamber (21) or the outflow chamber (22).

4. The liquid cooling module (3, 3, 3b, 3c, 3d) according to claim 3, wherein the liquid cooling module (3, 3, 3b, 3c, 3d) further comprises:
a cooling-flow-channel inlet (31) passing through and disposed on the bottom cover (30) and in fluid communication with the inflow chamber (21); and
a cooling-flow-channel outlet (32) passing through and disposed on the bottom cover (30) and in fluid communication with the outflow chamber (22).

5. The liquid cooling module (3, 3, 3b, 3c, 3d) according to claim 1, wherein the liquid cooling module (3, 3, 3b, 3c, 3d) further comprises:
a cooling-flow-channel inlet (31) disposed adjacent to the third lateral side (13) and in fluid communication with the inflow chamber (21); and
a cooling-flow-channel outlet (32) disposed adjacent to the fourth lateral side (14) and in fluid communication with the outflow chamber (22).

6. The liquid cooling module (3, 3, 3b, 3c, 3d) according to claim 5, further comprising a bottom cover (30), wherein the bottom cover (30) is assembled with the first lateral side (11), the second lateral side (12), the third lateral side (13), the fourth lateral side (14) and the first surface (101), and connected to the partition wall (20, 20a) to form the inflow chamber (21) and the outflow chamber (22), wherein the cooling-flow-channel inlet (31) and the cooling-flow-channel outlet (32) pass through the bottom cover (30) and are disposed on the bottom cover (30).

7. The liquid cooling module (3, 3, 3b, 3c, 3d) according to claim 1, wherein the at least one diversion structure (25, 25a, 25b, 25c, 25d, 25e, 25f, 25g, 25h, 33a, 33b) has a first end connected to the partition wall (20, 20a) and a second end extended along the second direction.

8. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is circular in shape and located on a midline between each adjacent two of the plurality of first through holes (23a, 23b, 23c) or on a midline between each adjacent two of the plurality of second through holes (24a, 24b, 24c) to provide the diversion function.

9. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is in an elongated strip shape, spaced apart from the partition wall (20, 20a), and extended along the second direction.

10. The liquid cooling module (3, 3, 3b, 3c, 3d) according to claim 1, wherein the at least one diversion structure (25, 25a, 25b, 25c, 25d, 25e, 25f, 25g, 25h, 33a, 33b) is formed by irregular bending of the partition wall (20, 20a).

11. The liquid cooling module (3, 3, 3b, 3c, 3d) according to claim 1, wherein the plurality of first through holes (23a, 23b, 23c) and the plurality of second through holes (24a, 24b, 24c) are slotted holes extended along the first direction.

12. The liquid cooling module (3, 3, 3b, 3c, 3d) according to claim 1, the top cover (40) has a top side and a bottom side opposite to each other, the plurality of fins (42) are accommodated in the plurality of manifold chambers (41, 41b, 41c) and extended from the bottom side toward the second surface (102), and a heat dissipation surface (43) is disposed on the top side and thermally coupled with the plurality of fins (42).

13. The liquid cooling module (3, 3, 3b, 3c, 3d) according to claim 1, wherein the plurality of manifold chambers (41, 41b, 41c), the plurality of first through holes (23a, 23b, 23c) and the plurality of second through holes (24a, 24b, 24c) are equal in number of M, M is an integer, and M≧2.

14. The liquid cooling module (3, 3, 3b, 3c, 3d) according to claim 1, wherein the plurality of manifold chambers (41, 41b, 41c), the plurality of first through holes (23a, 23b, 23c) and the plurality of second through holes (24a, 24b, 24c) are correspondingly cooperated to form M flow channels (F1, F2, F3), and the M flow channels (F1, F2, F3) have a flow direction perpendicular to the first direction.
